# EUROPEAN PATENT APPLICATION

(11) **EP 4 585 724 A1**
(43) Date of publication of application: **16.07.2025**
(21) Application number: 23863107.1
(22) Date of filing: 31.08.2023
(51) Int. Cl.: C30B 25/20, C30B 29/38, C23C 16/34, H01L 21/205

(54) **GAN CRYSTAL AND METHOD FOR PRODUCING GAN CRYSTAL**

(30) Priority: 05.09.2022 JP 2022140786; 05.09.2022 JP 2022140787
(71) Applicant: Mitsubishi Chemical Corporation, Tokyo 100-8251 (JP); National Institute for Materials Science, Tsukuba-shi, Ibaraki 305-0047 (JP)
(72) Inventor: ISO, Kenji, Tokyo 100-8251 (JP); ODANI, Takafumi, Tokyo 100-8251 (JP); OSHIMA, Yuichi, Tsukuba-shi, Ibaraki 305-0047 (JP)
(74) Representative: Hoffmann Eitle
(86) International application number: PCT/JP2023/032036
(87) International publication number: WO 2024/053569

(57) **Abstract**

The present invention relates to a GaN crystal including a Zn-doped GaN layer. The Zn-doped GaN layer has a Zn concentration of 1.0 × 10¹⁶ atoms/cm³ or more and 1.0 × 10²⁰ atoms/cm³ or less, and a full width at half maximum of a X-ray diffraction rocking curve of a (004) plane being 50 arcsec or less, or a full width at half maximum of a X-ray diffraction rocking curve of a (201) plane being 50 arcsec or less.

## Description

### TECHNICAL FIELD

The present invention relates to a gallium nitride (GaN) crystal and a method for producing the same.

### BACKGROUND ART

In recent years, a GaN-based high electron mobility transistor (HEMT) (hereinafter, may be referred to as "GaN-HEMT") has been actively developed for radio-frequency devices of several tens of GHz to several hundreds of GHz.

The GaN-HEMT is formed by the crystal growth of GaN on a substrate. Silicon, silicon carbide (SiC), GaN, and the like have been studied as substrates used for a GaN-HEMT, and a GaN-HEMT using a GaN substrate is expected to have excellent performance compared with a GaN-HEMT using another substrate.

The GaN-HEMT repeatedly turns a current on and off at the radio frequency, but ideally, it is required that no current flows when the device is in an OFF state. Therefore, a GaN substrate used for the GaN-HEMT is required to have a high resistance, and the GaN substrate is made semi-insulating to be a semi-insulating substrate (SI substrate).

A method for performing doping with a transition metal element has been common as a method for making a GaN substrate semi-insulating. The transition metal element acts as an acceptor, and therefore, the transition metal element compensates for a background donor unintentionally introduced into the GaN substrate, and has an effect of decreasing a carrier concentration of the GaN substrate. The transition metal element is referred to as a compensation impurity.

For example, in the invention described in Non-Patent Literature 1, a GaN crystal doped with iron (Fe) or manganese (Mn) as a compensation impurity is obtained. Further, in Patent Literatures 1 and 2, a GaN crystal doped with zinc (Zn) as a compensation impurity is obtained.

### CITATION LIST

### PATENT LITERATURE

Patent Literature 1: JP2011-020896A
Patent Literature 2: JPS60-65798A

### NON-PATENT LITERATURE

Non Patent Literature 1: M Iwinska et al., "Iron and manganese as dopants used in the crystallization of highly resistive HVPE-GaN on native seeds", Japanese Journal of Applied Physics, Vol. 58, SC1047, 2019

### SUMMARY OF INVENTION

### TECHNICAL PROBLEM

When Fe is used as a compensation impurity, specific resistance of the obtained GaN crystal is relatively small. Therefore, when the obtained GaN crystal is used as an SI substrate for a device, a leakage current of the device may increase. In addition, when Mn is used as a compensation impurity, specific resistance of the obtained GaN crystal is large, but Mn tends to easily diffuse in the GaN crystal. Therefore, when the obtained GaN crystal is used as an SI substrate for a device, an increase in on-resistance due to current collapse is a concern.

Patent Literature 1 discloses a GaN crystal obtained by a flux method using Zn as a compensation impurity other than the above Fe and Mn. Patent Literature 2 discloses a GaN crystal layer doped with Zn by a MOCVD method using an organic zinc compound as a dopant precursor.

However, when the above Zn-doped GaN crystal is used as the SI substrate, a GaN crystal satisfying all of high specific resistance, prevention of occurrence of current collapse, and high crystal quality has not been achieved.

Therefore, a first object of the present invention is to provide a GaN crystal which has excellent crystal quality and achieves high specific resistance and prevention of occurrence of current collapse, and a method for producing the same.

When the above Zn-doped GaN crystal is used as the SI substrate, there is room for improvement in crystal quality. Furthermore, when an attempt was made to obtain a Zn-doped GaN crystal layer by the MOCVD method, a crystal growth rate was extremely low, and it was not possible to obtain a free-standing GaN substrate.

Therefore, a second object of the present invention is to provide a GaN crystal which has excellent crystal quality and can be a free-standing substrate, and a method for producing the same.

### SOLUTION TO PROBLEM

That is, the gist of the present invention is as follows.
[1] A GaN crystal including:
   a Zn-doped GaN layer,
   in which the Zn-doped GaN layer has a Zn concentration of 1.0 × 10¹⁶ atoms/cm³ or more and 1.0 × 10²⁰ atoms/cm³ or less, and a full width at half maximum of a X-ray diffraction rocking curve of a (004) plane being 50 arcsec or less.
[2] A GaN crystal including:
   a Zn-doped GaN layer,
   in which the Zn-doped GaN layer has a Zn concentration of 1.0 × 10¹⁶ atoms/cm³ or more and 1.0 × 10²⁰ atoms/cm³ or less, and a full width at half maximum of a X-ray diffraction rocking curve of a (201) plane being 50 arcsec or less.
[3] The GaN crystal according to [1] or [2], in which the Zn-doped GaN layer has a C concentration of 1.0 × 10¹⁸ atoms/cm³ or less.
[4] The GaN crystal according to any one of [1] to [3], in which the Zn-doped GaN layer has a thickness of 50 µm or more.
[5] The GaN crystal according to any one of [1] to [4], in which an alkali metal concentration of a crystal surface of the Zn-doped GaN layer is 10 ppm or less.
[6] The GaN crystal according to any one of [1] to [5], in which the Zn-doped GaN layer contains no alkali metal inclusions.
[7] The GaN crystal according to any one of [1] to [6], in which a peak of light emitted when the Zn-doped GaN layer is irradiated with light having an energy larger than bandgap energy of GaN is not present in a region of 2.64 eV or more and 2.82 eV or less.
[8] The GaN crystal according to any one of [1] to [7], in which the Zn-doped GaN layer has a specific resistance at 300 K of 1 × 10⁹ Ωcm or more.
[9] The GaN crystal according to any one of [1] to [8], in which the Zn-doped GaN layer has a surface inclined by 10 degrees or less from a (0001) crystal plane.
[10] The GaN crystal according to any one of [1] to [9], in which the Zn-doped GaN layer has a total donor impurity concentration of less than 5.0 × 10¹⁶ atoms/cm³.
[11] The GaN crystal according to any one of [1] to [10], in which both an O (oxygen) content and a Si (silicon) content of the Zn-doped GaN layer are 1.0 × 10¹⁵ atoms/cm³ or more.
[12] A GaN crystal including:
   a Zn-doped GaN layer,
   in which the Zn-doped GaN layer has a specific resistance at 300 K of 1 × 10⁹ Ωcm or more.
[13] A method for producing a GaN crystal by a vapor phase growth method, the GaN crystal including a Zn-doped GaN layer having a Zn concentration of 1.0 × 10¹⁶ atoms/cm³ or more and 1.0 × 10²⁰ atoms/cm³or less, the method including:
   using metallic Zn as a doping precursor.
[14] A method for producing a GaN crystal by a vapor phase growth method, the GaN crystal including a Zn-doped GaN layer having a Zn concentration of 1.0 × 10¹⁶ atoms/cm³ or more and 1.0 × 10²⁰ atoms/cm³ or less and a thickness of 50 µm or more, the method including:
   using an organic Zn compound as a doping precursor.
[15] The method for producing a GaN crystal according to [13] or [14], in which the vapor phase growth method is an HVPE method.

The gist of an aspect A corresponding to the above first object of the present invention is as follows.
[1] A GaN crystal including:
   a Zn-doped GaN layer,
   in which the Zn-doped GaN layer has a Zn concentration of 1.0 × 10¹⁶ atoms/cm³ or more and 1.0 × 10²⁰ atoms/cm³ or less, a C concentration of 1.0 × 10¹⁸ atoms/cm³ or less, and a full width at half maximum of a X-ray diffraction rocking curve of a (004) plane being 50 arcsec or less.
[2] A GaN crystal including:
   a Zn-doped GaN layer,
   in which the Zn-doped GaN layer has a Zn concentration of 1.0 × 10¹⁶ atoms/cm³ or more and 1.0 × 10²⁰ atoms/cm³ or less, a C concentration of 1.0 × 10¹⁸ atoms/cm³ or less, and a full width at half maximum of a X-ray diffraction rocking curve of a (201) plane being 50 arcsec or less.
[3] The GaN crystal according to [1] or [2], in which an alkali metal concentration of a crystal surface of the Zn-doped GaN layer is 10 ppm or less.
[4] The GaN crystal according to any one of [1] to [3], in which the Zn-doped GaN layer contains no alkali metal inclusions.
[5] The GaN crystal according to any one of [1] to [4], in which a peak of light emitted when the Zn-doped GaN layer is irradiated with light having an energy larger than bandgap energy of GaN is not present in a region of 2.64 eV or more and 2.82 eV or less.
[6] The GaN crystal according to any one of [1] to [5], in which the Zn-doped GaN layer has a thickness of 50 µm or more.
[7] The GaN crystal according to any one of [1] to [6], in which the Zn-doped GaN layer has a specific resistance at 300 K of 1 × 10⁹ Ωcm or more.
[8] The GaN crystal according to any one of [1] to [7], in which the Zn-doped GaN layer has a surface inclined by 10 degrees or less from a (0001) crystal plane.
[9] The GaN crystal according to any one of [1] to [8], in which the Zn-doped GaN layer has a total donor impurity concentration of less than 5.0 × 10¹⁶ atoms/cm³.
[10] The GaN crystal according to any one of [1] to [9], in which both an O (oxygen) concentration and a Si (silicon) concentration of the Zn-doped GaN layer are 1.0 × 10¹⁵ atoms/cm³ or more.
[11] A method for producing a GaN crystal by a vapor phase growth method, the GaN crystal including a Zn-doped GaN layer having a Zn concentration of 1.0 × 10¹⁶ atoms/cm³ or more and 1.0 × 10²⁰ atoms/cm³ or less, the method including:
   using metallic Zn as a doping precursor.
[12] The method for producing a GaN crystal according to [11], in which the vapor phase growth method is an HVPE method.

The gist of an aspect B corresponding to the above second object of the present invention is as follows.
[1] A GaN crystal including:
   a Zn-doped GaN layer,
   in which the Zn-doped GaN layer has a Zn concentration of 1.0 × 10¹⁶ atoms/cm³ or more and 1.0 × 10²⁰ atoms/cm³ or less, a thickness of 50 µm or more, and a full width at half maximum of a X-ray diffraction rocking curve of a (004) plane being 50 arcsec or less.
[2] A GaN crystal including:
   a Zn-doped GaN layer,
   in which the Zn-doped GaN layer has a Zn concentration of 1.0 × 10¹⁶ atoms/cm³ or more and 1.0 × 10²⁰ atoms/cm³ or less, a thickness of 50 µm or more, and a full width at half maximum of a X-ray diffraction rocking curve of a (201) plane being 50 arcsec or less.
[3] The GaN crystal according to [1] or [2], in which an alkali metal concentration of a crystal surface of the Zn-doped GaN layer is 10 ppm or less.
[4] The GaN crystal according to any one of [1] to [3], in which the Zn-doped GaN layer contains no alkali metal inclusions.
[5] The GaN crystal according to any one of [1] to [4], in which a peak of light emitted when the Zn-doped GaN layer is irradiated with light having an energy larger than bandgap energy of GaN is not present in a region of 2.64 eV or more and 2.82 eV or less.
[6] The GaN crystal according to any one of [1] to [5], in which the Zn-doped GaN layer has a C concentration of 1.0 × 10¹⁸ atoms/cm³ or less.
[7] The GaN crystal according to any one of [1] to [6], in which the Zn-doped GaN layer has a specific resistance at 300 K of 1 × 10⁹ Ωcm or more.
[8] The GaN crystal according to any one of [1] to [7], in which the Zn-doped GaN layer has a surface of 5 cm² or more inclined by 10 degrees or less from a (0001) crystal plane.
[9] The GaN crystal according to any one of [1] to [8], in which the Zn-doped GaN layer has a total donor impurity concentration of less than 5.0 × 10¹⁶ atoms/cm³.
[10] The GaN crystal according to any one of [1] to [9], in which both an O (oxygen) concentration and a Si (silicon) concentration of the Zn-doped GaN layer are 1.0 × 10¹⁵ atoms/cm³ or more.
[11] A method for producing a GaN crystal by a vapor phase growth method, the GaN crystal including a Zn-doped GaN layer having a Zn concentration of 1.0 × 10¹⁶ atoms/cm³ or more and 1.0 × 10²⁰ atoms/cm³ or less and a thickness of 50 µm or more, the method including:
   using an organic Zn compound as a doping precursor.
[12] The method for producing a GaN crystal according to [11], in which the vapor phase growth method is an HVPE method.

### ADVANTAGEOUS EFFECTS OF INVENTION

According to the present invention, a GaN crystal which is excellent in crystal quality and achieves high specific resistance and prevention of occurrence of current collapse is provided. Therefore, the GaN epitaxial substrate is very suitable as a substrate used for a nitride semiconductor device having a horizontal device structure such as a GaN-HEMT.

The present invention also provides a GaN crystal which is excellent in crystal quality and has a thickness equal to or larger than a certain thickness. The GaN crystal of the present invention can be used as a free-standing substrate having a relatively high specific resistance. Therefore, the GaN crystal is very suitable as a substrate used for a nitride semiconductor device having a horizontal device structure such as a GaN-HEMT.

### BRIEF DESCRIPTION OF DRAWINGS

[FIG. 1] FIG. 1 is a plan view illustrating a (0001) surface of a GaN crystal according to the present embodiment, which is divided into cells each having a size of 5 mm × 5 mm by square lattices.
[FIG. 2] FIG. 2 is a cross-sectional view illustrating an aspect of the GaN crystal according to the present embodiment.
[FIG. 3] FIG. 3 is a cross-sectional view illustrating an aspect of the GaN crystal according to the present embodiment.
[FIG. 4] FIG. 4 is a process cross-sectional view illustrating a method for producing the GaN crystal according to the present embodiment. FIG. 4 (a) illustrates a state of a c-plane GaN seed, FIG. 4 (b) illustrates a state where a GaN layer is laminated on the c-plane GaN seed, and FIG. 4 (c) illustrates a state where the GaN layer which is a laminated structure is thinned.
[FIG. 5] FIG. 5 is a process cross-sectional view illustrating a method for producing a c-plane GaN seed used for producing the GaN crystal according to the present embodiment. FIG. 5 (a) illustrates a state of a seed wafer, FIG. 5 (b) illustrates a state where a thick GaN film has grown on the c-plane GaN seed, and FIG. 5 (c) illustrates a state where at least one c-plane GaN seed is obtained by processing the thick GaN film.
[FIG. 6] FIG. 6 is a schematic diagram showing a basic configuration of an HVPE device.
[FIG. 7] FIG. 7 is an emission spectrum, obtained when a GaN crystal obtained in Example A-1 was irradiated with light of 3.81 eV.
[FIG. 8] FIG. 8 is an emission spectrum, obtained when a GaN crystal obtained in Example B-1 was irradiated with light of 3.81 eV.

### DESCRIPTION OF EMBODIMENTS

Hereinafter, embodiments of the present invention are specifically described, but the present invention is not limited to the following embodiments, and the present invention can be implemented with various modifications within the scope of a gist thereof.

In the present disclosure, a crystal axis parallel to a [0001] axis is called a c-axis, a crystal axis parallel to a <10-10> axis is called an m-axis, and a crystal axis parallel to a <11-20> axis is called an a-axis. A crystal plane perpendicular to the c-axis is called a c-plane, a crystal plane perpendicular to the m-axis is called an m-plane, and a crystal plane perpendicular to the a-axis is called an a-plane.

The Miller index (h k i l) of a hexagonal crystal has a relationship of h + k = -i, and therefore, it may also be represented by three digits of (h k 1). For example, when (0 0 0 4) is expressed in three digits, it is (0 0 4).

In the present description, when referring to a crystal axis, a crystal plane, a crystal orientation, and the like, they mean a crystal axis, a crystal plane, a crystal orientation, and the like in a GaN substrate or a GaN layer, unless otherwise specified.

In the present description, concentrations such as a Zn concentration, a C concentration, an O concentration, and a Si concentration of a specific position are values determined by respective detection amounts using secondary ion mass spectrometry (SIMS).

In the present description, the expression "to" is used as an expression including numerical values or physical property values before and after the expression. That is, "A to B" means A or more and B or less.

### <<GaN Crystal (1)>>

A GaN crystal according to the present embodiment includes a Zn-doped GaN layer.

The above Zn-doped GaN layer has a Zn concentration of 1.0 × 10¹⁶ atoms/cm³ or more and 1.0 × 10²⁰ atoms/cm³ or less, and a full width at half maximum of a X-ray diffraction rocking curve of a (004) plane being 50 arcsec or less.

The above Zn-doped GaN layer may have a Zn concentration of 1.0 × 10¹⁶ atoms/cm³ or more and 1.0 × 10²⁰ atoms/cm³ or less, and a full width at half maximum of a X-ray diffraction rocking curve of a (201) plane being 50 arcsec or less.

The above Zn-doped GaN layer may satisfy both the full width at half maximum of the rocking curve obtained by (004) X-ray diffraction of 50 arcsec or less and the full width at half maximum of the rocking curve obtained by (201) X-ray diffraction of 50 arcsec or less.

In the GaN crystal according to the present embodiment, as the aspect A, the above Zn-doped GaN layer preferably has a C concentration of 1.0 × 10¹⁸ atoms/cm³ or less. As the aspect B, the Zn-doped GaN layer preferably has a thickness of 50 µm or more.

The above aspects A and B will be described below in order.

However, the GaN crystal according to the present embodiment is not limited only to the aspects A and B.

That is, the GaN crystal according to the present embodiment does not necessarily satisfy at least one of the condition that the C concentration of the Zn-doped GaN layer is 1.0 × 10¹⁸ atoms/cm³ or less (aspect A) and the condition that the thickness of the Zn-doped GaN layer is 50 µm or more (aspect B). A preferred aspect of the GaN crystal according to the present embodiment is the same as the preferred aspect of the aspect A or the aspect B even when the GaN crystal does not satisfy both the condition that the C concentration of the Zn-doped GaN layer is 1.0 × 10¹⁸ atoms/cm³ or less (aspect A) and the condition that the thickness of the Zn-doped GaN layer is 50 µm or more (aspect B).

### <Aspect A>

### [GaN Crystal According to First Embodiment]

A GaN crystal according to a first embodiment of the aspect A is a GaN crystal including a Zn-doped GaN layer. The Zn-doped GaN layer has a Zn concentration of 1.0 × 10¹⁶ atoms/cm³ or more and 1.0 × 10²⁰ atoms/cm³ or less, a C concentration of 1.0 × 10¹⁸ atoms/cm³ or less, and a full width at half maximum of a X-ray diffraction rocking curve of a (004) plane being 50 arcsec or less.

The Zn-doped GaN layer is made of a GaN crystal layer doped with Zn. By containing Zn at a specific concentration, the GaN layer is increased in resistance, and by maintaining the C concentration at or below the above upper limit, the occurrence of current collapse derived from C can be prevented.

In an aspect of the GaN crystal according to the first embodiment, the Zn concentration of the entire crystal is 1.0 × 10¹⁶ atoms/cm³ or more and 1.0 × 10²⁰ atoms/cm³ or less, and the C concentration is 1.0 × 10¹⁸ atoms/cm³ or less. That is, the GaN crystal is formed of only the Zn-doped GaN layer.

In another aspect of the GaN crystal according to the first embodiment, the GaN crystal has a Zn-doped GaN layer having a Zn concentration of 1.0 × 10¹⁶ atoms/cm³ or more and 1.0 × 10²⁰ atoms/cm³ or less and a C concentration of 1.0 × 10¹⁸ atoms/cm³ or less. In this case, the thickness of the Zn-doped GaN layer in a c-axis direction is not required to coincide with a thickness of the entire GaN crystal in the c-axis direction.

For example, a thickness of the entire GaN crystal is 400 µm, whereas the thickness of the Zn-doped GaN layer is sufficient if it is included in top 100 µm of the GaN crystal. Of course, the thickness of the Zn-doped GaN layer is not limited to the above, and the cases where the thickness of the Zn-doped GaN layer is larger or smaller than the above are not excluded at all. In addition, the GaN crystal may be a GaN crystal in which the entire GaN crystal in the thickness direction is formed of a Zn-doped GaN layer, and this case corresponds to the above-described case where the Zn concentration of the entire GaN crystal is 1.0 × 10¹⁶ atoms/cm³ or more and 1.0 × 10²⁰ atoms/cm³ or less and the C concentration is 1.0 × 10¹⁸ atoms/cm³ or less.

The Zn-doped GaN layer having a Zn concentration of 1.0 × 10¹⁶ atoms/cm³ or more and 1.0 × 10²⁰ atoms/cm³ or less and a C concentration of 1.0 × 10¹⁸ atoms/cm³ or less may have various thicknesses, and may have various forms such as a free-standing substrate, an epitaxial layer grown on another GaN crystal, and a GaN layer laminated on a support substrate by a bonding technique.

For example, the thickness of the Zn-doped GaN layer is preferably 50 µm or more, more preferably 80 µm or more, and still more preferably 100 µm or more from the viewpoint of handleability that a free-standing GaN substrate can be obtained by processing. The upper limit of the above thickness is not particularly limited, and the thickness is preferably, for example, 200 µm or less.

A Zn concentration of the Zn-doped GaN layer is preferably 1.0 × 10¹⁶ atoms/cm³ or more and 1.0 × 10²⁰ atoms/cm³ or less. Zn, which is a compensation impurity, contributes to an increase in resistance, and when the Zn concentration is 1.0 × 10¹⁶ atoms/cm³ or more, a high specific resistance of the Zn-doped GaN layer can be achieved. When the Zn concentration of the Zn-doped GaN layer is 1.0 × 10²⁰ atoms/cm³ or less, good crystal quality can be maintained.

From the viewpoint of the impurity levels, the doping with Zn is superior to the doping with other compensation impurities such as Fe (iron). This is because a level of Zn is deeper than that of Fe, and greater energy is required for trapped electrons to return to a conduction band.

The Zn concentration of the Zn-doped GaN layer is 1.0 × 10²⁰ atoms/cm³ or less, and is preferably 6.0 × 10¹⁹ atoms/cm³ or less, 5.0 × 10¹⁹ atoms/cm³ or less, 3.0 × 10¹⁹ atoms/cm³ or less, 1.0 × 10¹⁹ atoms/cm³ or less, or 5.0 × 10¹⁸ atoms/cm³ or less, in a stepwise manner.

The Zn concentration of the Zn-doped GaN layer is 1.0 × 10¹⁶ atoms/cm³ or more, and is preferably 3.0 × 10¹⁶ atoms/cm³ or more, 5.0 × 10¹⁶ atoms/cm³ or more, 1.0 × 10¹⁷ atoms/cm³ or more, or 3.0 × 10¹⁷ atoms/cm³ or more, in a stepwise manner.

The C concentration of the Zn-doped GaN layer is 1.0 × 10¹⁸ atoms/cm³ or less. C, which is a compensation impurity, can contribute to an increase in resistance. Meanwhile, in the case where C is contained in an amount equal to or larger than a certain amount, a current collapse phenomenon may occur when a GaN crystal including a Zn-doped GaN layer is used for a device. Therefore, from the viewpoint of reducing the risk of causing the current collapse phenomenon, the C concentration of the Zn-doped GaN layer is preferably low.

The C concentration of the Zn-doped GaN layer is 1.0 × 10¹⁸ atoms/cm³ or less, and is preferably 8.0 × 10¹⁷ atoms/cm³ or less, 5.0 × 10¹⁷ atoms/cm³ or less, 3.0 × 10¹⁷ atoms/cm³ or less, 1.0 × 10¹⁷ atoms/cm³ or less, 5.0 × 10¹⁶ atoms/cm³ or less, or 2.0 × 10¹⁶ atoms/cm³ or less, in a stepwise manner. The lower limit of the C concentration of the GaN crystal is not particularly limited and is generally equal to the detection limit.

As impurities acting as donors for GaN, O (oxygen), Si (silicon), S (sulfur), Ge (germanium), Sn (tin), and the like are common, and referred to as donor impurities.

The donor impurities inhibit the effect of increasing the resistance caused by the compensation impurity. Therefore, a sum of the concentrations of the donor impurities contained in the Zn-doped GaN layer, that is, the total donor impurity concentration is preferably less than 5.0 × 10¹⁶ atoms/cm³, more preferably less than 4.0 × 10¹⁶ atoms/cm³, and still more preferably less than 2.0 × 10¹⁶ atoms/cm³, from the viewpoint that the resistivity of the Zn-doped GaN layer is hardly affected by the variation in the donor impurity concentration and a high resistivity can be achieved even at a relatively low Zn concentration. The amount of donor impurities is preferably as small as possible, and therefore, the lower limit of the total donor impurity concentration is not particularly limited.

As described later, the Zn-doped GaN layer in the present embodiment can be grown by, for example, preferably a vapor phase growth method, and more preferably a hydride vapor phase epitaxy (HVPE) method. Even though O (oxygen) and Si (silicon), which are donor impurities, are not intentionally added to the Zn-doped GaN layer obtained by the above method, O and Si can be respectively contained at concentrations in a range of 10¹⁵ atoms/cm³ or more. That is, both the O (oxygen) concentration and the Si (silicon) concentration of the Zn-doped GaN layer may be 1.0 × 10¹⁵ atoms/cm³ or more.

On the other hand, donor impurities other than O and Si are contained in the Zn-doped GaN layer at a non-negligible concentration only when the GaN substrate is intentionally doped with such donor impurities. Note that "intentionally doping" means, for example, a case where the element is added in the form of a simple substance or a compound as a raw material in order to dope the Zn-doped GaN layer with the target element.

Therefore, unless the Zn-doped GaN layer is intentionally doped with the donor impurities other than O and Si, the total donor impurity concentration of the Zn-doped GaN layer may be considered to be equal to the sum of the O concentration and the Si concentration. Whether the Zn-doped GaN layer is doped with the donor impurities other than O and Si can be checked by an elemental analysis or the like.

The Zn-doped GaN layer may contain compensation impurities other than Zn and C, such as Fe (iron), Co (cobalt), and Ni (nickel), as long as no problem occurs in practical use. Alternatively, the Zn-doped GaN layer may be substantially free of compensation impurities other than Zn and C. In this case, the sum of concentrations of the compensation impurities other than Zn and C is, for example, 1 × 10¹⁶ atoms/cm³ or less.

The Zn-doped GaN layer may contain H (hydrogen) in addition to the donor impurities and the compensation impurities described above, and the concentration of H may be, for example, in a range of 10¹⁶ to 10¹⁷ atoms/cm³.

The full width at half maximum of a X-ray diffraction rocking curve of a (004) plane of the Zn-doped GaN layer is 50 arcsec or less. The rocking curve is a diffraction intensity distribution in the case where a direction of incident X-rays and a position of a detector are fixed and only a crystal as a sample is rotated in an X-ray diffraction measurement, and is one of indexes indicating crystal quality.

A smaller value of the full width at half maximum of the rocking curve means that the fewer crystal defects and the better crystal quality. The full width at half maximum is preferably 40 arcsec or less, more preferably 30 arcsec or less, and still more preferably 20 arcsec or less. The lower limit of the full width at half maximum is not particularly limited, and the full width at half maximum is generally 5 arcsec or more. The full width at half maximum in the present description has the same meaning as the half width in general. That is, the half width means a distance between positions indicating an intensity 1/2fₘₐₓ which is half the maximum intensity fₘₐₓ of a peak.

The full width at half maximum can be adjusted by a method of growing a GaN crystal layer in the Zn-doped GaN layer (a vapor phase method, a liquid phase method, or the like), the crystal characteristics, crystal growth conditions, selection of a surface for growth, the content of impurities, and the like of a seed substrate used for growing a GaN crystal layer.

CuKα 1 radiation is used for a rocking curve measurement obtained by (004) X-ray diffraction. In the measurement, an X-ray tube is operated, for example, at a voltage of 45 kV and a current of 40 mA. When X-rays enter a (0001) surface, the incident surface of the X-rays can be perpendicular to the a-axis or the m-axis.

A beam size of the X-ray can be set such that a size of an irradiation area on the (0001) surface is 5 mm in a direction parallel to a ω axis and 1 mm in a direction perpendicular to the ω axis when an incident angle (an angle formed between a reflection surface and the X-ray) is 90°, that is, when the X-ray is incident perpendicularly to a (004) reflection surface. The ω axis is the rotation axis of the sample in the rocking curve measurement, and an angle between the incident X-ray and the crystal surface is represented by ω.

When the beam size of the X-ray is set as described above, the size of the irradiation area is about 1.7 × 5 mm² because ω is about 36.5° in the rocking curve measurement using X-ray diffraction of (004).

In addition, similar to the measurement of (004), a rocking curve measurement of other crystal planes can be performed. For example, a measurement of (201) is often performed.

The full width at half maximum in the rocking curve of (004) is an index for observing the uniformity of a plane parallel to the c-axis, that is, the c-plane. On the other hand, the full width at half maximum in the rocking curve of (201) is an index for observing the rotational uniformity around the c-axis of a plane not parallel to the c-axis, that is, the c-plane.

The rocking curve measurement of a plane parallel to the c-axis is referred to as an on-axis measurement, and the rocking curve measurement of a plane not parallel to the c-axis is referred to as an off-axis measurement. The former correlates with a dislocation density having a screw dislocation component, and the latter correlates with a dislocation density having an edge dislocation component. In order to evaluate the crystal quality, it is preferable to perform both the on-axis measurement and the off-axis measurement.

In the Zn-doped GaN layer in the present embodiment, an alkali metal concentration of the crystal surface is preferably 10 ppm or less. The Zn-doped GaN layer satisfying the above requirements means that a region having a partially high alkali metal concentration is not present in the Zn-doped GaN layer. As a region having a partially high alkali metal concentration is not present, the influence on a lattice length of the GaN crystal can be prevented, and cracking or the like can be prevented when a GaN crystal including a Zn-doped GaN layer is used as a substrate.

Note that ppm indicating the concentration in the present description means parts per million atomic (ppma) based on the number of atoms.

The alkali metal concentration of the crystal surface is more preferably 8 ppm or less, still more preferably 5 ppm or less, and is preferably as low as possible. The alkali metal concentration of the crystal surface is generally 0.1 ppm or more. The alkali metal concentration in the present description means an alkali metal concentration of any 100 µm × 100 µm square lattice on the crystal surface, and can be measured by, for example, scanning electron microscope-energy dispersive X-ray spectroscopy (SEM-EDX).

The Zn-doped GaN layer in the present embodiment preferably contains no alkali metal inclusions. The alkali metal inclusion means a closed space containing an alkali metal formed in the Zn-doped GaN layer when the alkali metal inclusion is present inside the crystal, and means a recessed portion formed by exposing the closed space to the crystal surface when the alkali metal inclusion is present on the crystal surface.

In the case where a GaN crystal including a Zn-doped GaN layer containing alkali metal inclusions inside the crystal or on the crystal surface is used as a substrate, when a GaN crystal layer is epitaxially grown on the substrate, the alkali metal such as Na, contained in the closed space volatilizes and expands in volume, which may cause cracking of the substrate, or may cause the crystal quality of the epitaxially grown GaN crystal layer to deteriorate. It is common that such a closed space can be generally generated in a GaN crystal when the GaN crystal is obtained by a flux method. The presence or absence of the alkali metal inclusions can be determined by an optical microscope or an SEM.

In the Zn-doped GaN layer in the present embodiment, it is also preferable that a peak of light emitted when the Zn-doped GaN is irradiated with light having energy larger than bandgap energy of GaN is not present in a region of 2.64 eV to 2.82 eV. Among the flux methods, for example, it is common that when a GaN crystal produced by the Na flux method is irradiated with the above light, broad light emission generally has a peak at 2.64 eV to 2.82 eV. It can be presumed that the GaN crystal is obtained by the Na flux method when the above peak is present.

As described above, the GaN crystal produced by the flux method may have a region having a high alkali metal concentration on the crystal surface or may have alkali metal inclusions, and may not be desirable as a semi-insulating GaN crystal for devices requiring high reliability.

In contrast, the Zn-doped GaN layer produced according to the vapor phase growth method emits light having a peak in a region of 2.88 eV to 2.98 eV by irradiating with the same light. The emission is derived from Zn and is distinguished from that derived from Na. Therefore, the Zn-doped GaN layer obtained according to the Na flux method and the Zn-doped GaN layer obtained according to the vapor phase method can be distinguished from each other based on the fact that no emission peak is present in the region of 2.64 eV to 2.82 eV or an emission peak is present in the region of 2.88 eV to 2.98 eV by irradiating with the above light.

As described above, the GaN crystal according to the first embodiment may be formed of a Zn-doped GaN crystal in which the Zn concentration of the entire crystal is 1.0 × 10¹⁶ atoms/cm³ or more and 1.0 × 10²⁰ atoms/cm³ or less, that is, may be formed of only the above Zn-doped GaN layer, and the GaN crystal may also have a configuration in which the above Zn-doped GaN layer having a Zn concentration of 1.0 × 10¹⁶ atoms/cm³ or more and 1.0 × 10²⁰ atoms/cm³ or less is laminated on a seed crystal layer formed of GaN.

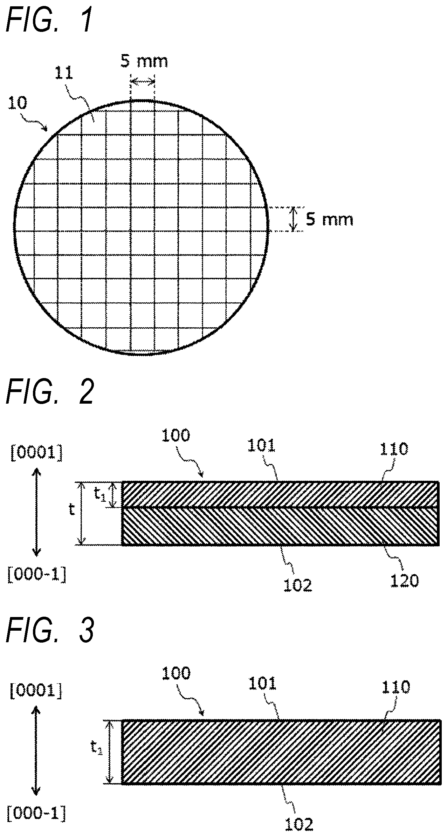

In the case where the GaN crystal includes the Zn-doped GaN layer and the seed crystal layer, the GaN crystal according to the first embodiment includes a first region 110 and a second region 120 as shown in FIG. 2.

FIG. 2 shows a cross section obtained by cutting a GaN crystal 100 along a plane perpendicular to a (0001) surface 101.

In the GaN crystal 100, the first region 110 including the (0001) surface 101 is preferably made of a Zn-doped GaN layer.

The GaN crystal 100 may have the second region 120 on a (000-1) surface 102 side, and the second region 120 may be made of a GaN crystal layer having a room temperature resistivity of less than 1 × 10⁵ Ωcm (that is, a GaN crystal layer that is not semi-insulating).

A total concentration of compensation impurities in the second region 120 is generally lower than that of the first region 110. The second region 120 may have, in a vicinity of a boundary with the first region 110, a region in which the total concentration of the compensation impurities increases stepwise or continuously as approaching the first region 110.

The GaN crystal 100 having the first region 110 and the second region 120 can be produced by forming the second region 120 on the first region 110 by epitaxial growth or forming the first region 110 on the second region 120 by epitaxial growth.

An example of the GaN crystal according to the first embodiment has the Ga polar (0001) surface 101 and the N polar (000-1) surface 102.

In the case where the GaN crystal 100 includes the seed crystal layer and the Zn-doped GaN layer, a surface of the first region 110 which is the Zn-doped GaN layer is the (0001) surface 101, and a surface of the second region 120 which is the seed crystal layer is the (000-1) surface 102, as shown in FIG. 2.

In the case where the GaN crystal 100 is formed of only a Zn-doped GaN layer as a whole, one surface of the Zn-doped GaN layer which is the first region 110 is the (0001) surface 101, and the other surface is the (000-1) surface 102, as shown in FIG. 3.

The Zn-doped GaN layer in the first embodiment preferably has a surface inclined by 10 degrees or less from the (0001) crystal plane. In the present description, the term "surface having inclination of 10 degrees or less from the (0001) crystal plane" may be abbreviated as a "(0001) surface". The expression "inclined by 10 degrees or less" is a concept also including the case of being inclined by 0 degree.

The GaN crystal according to the first embodiment may have any shape, and preferably has a shape from which a GaN substrate described later can be obtained.

An area of the (0001) surface of the Zn-doped GaN layer may be, for example, 1 cm² or more, 5 cm² or more, 10 cm² or more, 18 cm² or more, 75 cm² or more, or 165 cm² or more. The upper limit thereof is not particularly limited, and the area may be, for example, 350 cm² or less.

The GaN crystal according to the first embodiment may be grown in any direction, and is preferably grown on a surface inclined by 10 degrees or less (including 0 degree) from the (0001) crystal plane.

In the GaN crystal according to the first embodiment, the (0001) surface is preferably a main surface, that is, a large-area surface. In addition, an area ratio of the (0001) surface in the crystal growth surface is preferably 60% or more, more preferably 70% or more, and still more preferably 80% or more, and the upper limit is 100%.

When the area of the (0001) surface is large, the total donor impurity concentration can be kept low, and semi-insulating properties can be obtained even if the Zn concentration is relatively low, as described later. The same applies to the case where the area ratio of the (0001) surface to the crystal growth surface is within the above range.

When the GaN crystal according to the first embodiment has a disk shape, a diameter thereof is generally 20 mm or more, and may be 25 mm or more, 40 mm or more, 50 mm or more, or 90 mm or more in a stepwise manner. The above diameter may be any size such as 25 mm to 27 mm (about 1 inch), 50 mm to 55 mm (about 2 inches), 100 mm to 105 mm (about 4 inches), or 150 mm to 155 mm (about 6 inches). When the GaN crystal has a shape other than the disk shape, a size where the diameter of the disk shape having the same area as the main surface is within the above range can be adopted.

In the case of the GaN substrate, a thickness t of the GaN crystal is set, based on the diameter, to a value at which handling of the GaN substrate is not difficult. For example, when the diameter of the GaN crystal is about 2 inches, the thickness of the GaN crystal is preferably 250 µm to 500 µm, and more preferably 300 µm to 450 µm.

In the case where the GaN crystal has a configuration in which the second region 120 made of the seed crystal layer and the first region 110 made of the Zn-doped GaN layer are laminated as illustrated in FIG. 2, the thickness t₁ of the first region 110 that is the Zn-doped GaN layer is preferably 50 µm to 200 µm, more preferably 80 µm to 200 µm, and still more preferably 100 µm to 150 µm.

In the case where the GaN crystal according to the first embodiment is a GaN substrate, the (0001) surface 101 of the two large-area surfaces of the GaN crystal is used for epitaxial growth of a nitride semiconductor layer as a front surface. The (0001) surface 101 is mirror-finished, and a root mean square (RMS) roughness thereof measured with an atomic force microscope (AFM) is generally less than 2 nm, preferably less than 1 nm, and more preferably less than 0.5 nm in a measurement range of 2 µm × 2 µm.

The (000-1) surface 102 is a back surface, and therefore, the plane may be mirror-finished or rough-finished.

An edge of the GaN substrate made of the GaN crystal according to the first embodiment may be chamfered.

The GaN substrate may be provided with various markings as necessary, such as orientation flats or notches for indicating an orientation of a crystal, and an index flat for facilitating the identification of a front surface and a back surface.

A shape of the GaN substrate is not particularly limited, and the shapes of the (0001) surface and the (000-1) surface may be a disk shape, a square shape, a rectangular shape, a hexagonal shape, an octagonal shape, an elliptical shape, or the like, or may be an irregular shape.

The Zn-doped GaN layer in the first embodiment preferably has a specific resistance of 1 × 10⁹ Ωcm or more at 300 K because the leakage current can be reduced when a GaN crystal is used as a high-resistance substrate for a device.

The specific resistance at 300 K is more preferably 5 × 10⁹ Ωcm or more, still more preferably 1 × 10¹⁰ Ωcm or more, yet still more preferably 5 × 10¹⁰ Ωcm or more, and particularly preferably 1 × 10¹¹ Ωcm or more. In addition, the upper limit is not particularly limited because a higher specific resistance is more preferred.

In the Zn-doped GaN layer in the first embodiment, the carrier type is preferably p-type. In the case where the crystal quality of the GaN crystal is not good, even if the GaN layer is doped with Zn, electrons caused by unintended impurities such as Si and O cannot be sufficiently compensated, and the carrier type tends to be n-type. Therefore, the carrier type of the Zn-doped GaN layer being p-type means that the crystallinity of the GaN single crystal layer forming the GaN crystal is good.

### [GaN Crystal According to Second Embodiment]

A GaN crystal according to a second embodiment of the aspect A includes a Zn-doped GaN layer. The Zn-doped GaN layer has a Zn concentration of 1.0 × 10¹⁶ atoms/cm³ or more and 1.0 × 10²⁰ atoms/cm³ or less, a C concentration of 1.0 × 10¹⁸ atoms/cm³ or less, and a full width at half maximum of a X-ray diffraction rocking curve of a (201) plane being 50 arcsec or less.

The full width at half maximum of the rocking curve obtained by (201) X-ray diffraction of the Zn-doped GaN layer in the second embodiment is an index for observing rotational uniformity around the c-axis of a plane not parallel to the c-axis, that is, the c-plane, as described for the full width at half maximum of the rocking curve by (004) X-ray diffraction of the Zn-doped GaN layer in the first embodiment.

A smaller full width at half maximum of the rocking curve obtained by (201) X-ray diffraction means a better crystal quality. The above full width at half maximum of the Zn-doped GaN layer is 50 arcsec or less, preferably 40 arcsec or less, more preferably 30 arcsec or less, and still more preferably 20 arcsec or less. The lower limit of the full width at half maximum is not particularly limited, and the full width at half maximum is generally 5 arcsec or more.

Preferred aspects of the Zn-doped GaN layer and the GaN crystal other than the above full width at half maximum of the rocking curve are the same as the preferred aspects of the Zn-doped GaN layer and the GaN crystal described in [GaN Crystal According to First Embodiment].

In the Zn-doped GaN layer, both the full widths at half maximum of the rocking curves obtained by X-ray diffraction of (004) and (201) are preferably 50 arcsec or less, more preferably 40 arcsec or less, still more preferably 30 arcsec or less, and particularly preferably 20 arcsec or less.

### <Aspect B>

### [GaN Crystal According to First Embodiment]

A GaN crystal according to a first embodiment of the aspect B is a GaN crystal including a Zn-doped GaN layer. The Zn-doped GaN layer has a Zn concentration of 1.0 × 10¹⁶ atoms/cm³ or more and 1.0 × 10²⁰ atoms/cm³ or less, a thickness of 50 µm or more, and a full width at half maximum of a X-ray diffraction rocking curve of a (004) plane being 50 arcsec or less.

The Zn-doped GaN layer is made of a GaN crystal layer doped with Zn. By containing Zn at a specific concentration, the GaN crystal has high resistance, and by having a thickness equal to or larger than a certain thickness, and the GaN crystal can be used as a free-standing substrate and thus is excellent in handleability.

In an aspect of the GaN crystal according to the first embodiment, the Zn concentration of the entire crystal is 1.0 × 10¹⁶ atoms/cm³ or more and 1.0 × 10²⁰ atoms/cm³ or less, and the thickness of the entire crystal is 50 µm or more. That is, the GaN crystal is formed of only the Zn-doped GaN layer.

In another aspect of the GaN crystal according to the first embodiment, the GaN crystal includes a Zn-doped GaN layer having a Zn concentration of 1.0 × 10¹⁶ atoms/cm³ or more and 1.0 × 10²⁰ atoms/cm³ or less and a thickness of 50 µm or more. In this case, the thickness of the Zn-doped GaN layer in a c-axis direction is not required to coincide with a thickness of the entire GaN crystal in the c-axis direction.

For example, a thickness of the entire GaN crystal is 400 µm, whereas the thickness of the Zn-doped GaN layer is sufficient if it is included in top 100 µm of the GaN crystal. Of course, the thickness of the Zn-doped GaN layer is not limited to the above example as long as it is 50 µm or more, and the case of being larger or smaller than the top 100 µm is not excluded at all. In addition, the GaN crystal may be a GaN crystal in which the entire GaN crystal in the thickness direction is formed of a Zn-doped GaN layer, and this case corresponds to the above-described case where the Zn concentration of the entire GaN crystal is 1.0 × 10¹⁶ atoms/cm³ or more and 1.0 × 10²⁰ atoms/cm³ or less and the thickness of the entire crystal is 50 µm or more.

The thickness of the Zn-doped GaN layer having a Zn concentration of 1.0 × 10¹⁶ atoms/cm³ or more and 1.0 × 10²⁰ atoms/cm³ or less may be 50 µm or more, more preferably 80 µm or more, and still more preferably 100 µm or more. The upper limit of the above thickness is not particularly limited, and the thickness is preferably, for example, 200 µm or less.

A Zn concentration of the Zn-doped GaN layer is preferably 1.0 × 10¹⁶ atoms/cm³ or more and 1.0 × 10²⁰ atoms/cm³ or less. Zn, which is a compensation impurity, contributes to an increase in resistance, and when the Zn concentration is 1.0 × 10¹⁶ atoms/cm³ or more, a high specific resistance of the Zn-doped GaN layer can be achieved. When the Zn concentration of the Zn-doped GaN layer is 1.0 × 10²⁰ atoms/cm³ or less, good crystal quality can be maintained.

From the viewpoint of the impurity levels, the doping with Zn is superior to the doping with other compensation impurities such as Fe (iron). This is because a level of Zn is deeper than that of Fe, and greater energy is required for trapped electrons to return to a conduction band.

The Zn concentration of the Zn-doped GaN layer is 1.0 × 10²⁰ atoms/cm³ or less, and is preferably 6.0 × 10¹⁹ atoms/cm³ or less, 5.0 × 10¹⁹ atoms/cm³ or less, 3.0 × 10¹⁹ atoms/cm³ or less, 1.0 × 10¹⁹ atoms/cm³ or less, or 5.0 × 10¹⁸ atoms/cm³ or less, in a stepwise manner.

The Zn concentration of the Zn-doped GaN layer is 1.0 × 10¹⁶ atoms/cm³ or more, and is preferably 3.0 × 10¹⁶ atoms/cm³ or more, 5.0 × 10¹⁶ atoms/cm³ or more, 1.0 × 10¹⁷ atoms/cm³ or more, or 3.0 × 10¹⁷ atoms/cm³ or more, in a stepwise manner.

The Zn-doped GaN layer may contain C as a compensation impurity. The depth of a C level is about 0.9 eV. On the other hand, our investigations have revealed that the depth of Zn level is larger than that. Therefore, regarding the semi-insulating property of GaN co-doped with Zn and C, Zn is more dominant than C, and thus the Zn-doped GaN layer may contain C.

The C concentration of the Zn-doped GaN layer is not particularly limited, and is preferably 1.0 × 10¹⁷ atoms/cm³ or more from the viewpoint of increasing the resistance, and is preferably 3.0 × 10¹⁷ atoms/cm³ or more, 5.0 × 10¹⁷ atoms/cm³ or more, 8.0 × 10¹⁷ atoms/cm³ or more, or 1.0 × 10¹⁸ atoms/cm³ or more, in a stepwise manner.

On the other hand, the C concentration of the Zn-doped GaN layer is preferably 5.0 × 10¹⁹ atoms/cm³ or less, and more preferably 2.0 × 10¹⁹ atoms/cm³ or less, 1.0 × 10¹⁹ atoms/cm³ or less, 8.0 × 10¹⁸ atoms/cm³ or less, or 5.0 × 10¹⁸ atoms/cm³ or less, from the viewpoint of avoiding unintended deterioration of crystal quality.

As impurities acting as donors for GaN, O (oxygen), Si (silicon), S (sulfur), Ge (germanium), Sn (tin), and the like are common, and referred to as donor impurities.

The donor impurities inhibit the effect of increasing the resistance caused by the compensation impurity. Therefore, a sum of the concentrations of the donor impurities contained in the Zn-doped GaN layer, that is, the total donor impurity concentration is preferably less than 5.0 × 10¹⁶ atoms/cm³, more preferably less than 4.0 × 10¹⁶ atoms/cm³, and still more preferably less than 2.0 × 10¹⁶ atoms/cm³, from the viewpoint that the resistivity of the Zn-doped GaN layer is hardly affected by the variation in the donor impurity concentration and a high resistivity can be achieved even at a relatively low Zn concentration. The amount of donor impurities is preferably as small as possible, and therefore, the lower limit of the total donor impurity concentration is not particularly limited.

As described later, the Zn-doped GaN layer in the present embodiment can be grown by, for example, preferably a vapor phase growth method, and more preferably a hydride vapor phase epitaxy (HVPE) method. Even though O (oxygen) and Si (silicon), which are donor impurities, are not intentionally added to the Zn-doped GaN layer obtained by the above method, O and Si can be respectively contained at concentrations in a range of 10¹⁵ atoms/cm³ or more. That is, both the O (oxygen) concentration and the Si (silicon) concentration of the Zn-doped GaN layer may be 1.0 × 10¹⁵ atoms/cm³ or more.

On the other hand, donor impurities other than O and Si are contained in the Zn-doped GaN layer at a non-negligible concentration only when the GaN substrate is intentionally doped with such donor impurities. Note that "intentionally doping" means, for example, a case where the element is added in the form of a simple substance or a compound as a raw material in order to dope the Zn-doped GaN layer with the target element.

Therefore, unless the Zn-doped GaN layer is intentionally doped with the donor impurities other than O and Si, the total donor impurity concentration of the Zn-doped GaN layer may be considered to be equal to the sum of the O concentration and the Si concentration. Whether the Zn-doped GaN layer is doped with the donor impurities other than O and Si can be checked by an elemental analysis or the like.

The Zn-doped GaN layer may contain compensation impurities other than Zn and C, such as Fe (iron), Co (cobalt), and Ni (nickel), as long as no problem occurs in practical use. Alternatively, the Zn-doped GaN layer may be substantially free of compensation impurities other than Zn and C. In this case, the sum of concentrations of the compensation impurities other than Zn and C is, for example, 1 × 10¹⁶ atoms/cm³ or less.

The Zn-doped GaN layer may contain H (hydrogen) in addition to the donor impurities and the compensation impurities described above, and the concentration of H may be, for example, in a range of 10¹⁶ to 10¹⁷ atoms/cm³.

The full width at half maximum of a X-ray diffraction rocking curve of a (004) plane of the Zn-doped GaN layer is 50 arcsec or less. The rocking curve is a diffraction intensity distribution in the case where a direction of incident X-rays and a position of a detector are fixed and only a crystal as a sample is rotated in an X-ray diffraction measurement, and is one of indexes indicating crystal quality.

A smaller value of the full width at half maximum of the rocking curve means that the fewer crystal defects and the better crystal quality. The full width at half maximum is preferably 40 arcsec or less, more preferably 30 arcsec or less, and still more preferably 20 arcsec or less. The lower limit of the full width at half maximum is not particularly limited, and the full width at half maximum is generally 5 arcsec or more. The full width at half maximum in the present description has the same meaning as the half width in general. That is, the half width means a distance between positions indicating an intensity 1/2fₘₐₓ which is half the maximum intensity fₘₐₓ of a peak.

The full width at half maximum can be adjusted by a method of growing a GaN crystal layer in the Zn-doped GaN layer (a vapor phase method, a liquid phase method, or the like), the crystal characteristics, crystal growth conditions, selection of a surface for growth, the content of impurities, and the like of a seed substrate used for growing a GaN crystal layer.

CuKα 1 radiation is used for a rocking curve measurement obtained by (004) X-ray diffraction. In the measurement, an X-ray tube is operated, for example, at a voltage of 45 kV and a current of 40 mA. When X-rays enter a (0001) surface, the incident surface of the X-rays can be perpendicular to the a-axis or the m-axis.

A beam size of the X-ray can be set such that a size of an irradiation area on the (0001) surface is 5 mm in a direction parallel to a ω axis and 1 mm in a direction perpendicular to the ω axis when an incident angle (an angle formed between a reflection surface and the X-ray) is 90°, that is, when the X-ray is incident perpendicularly to a (004) reflection surface. The ω axis is the rotation axis of the sample in the rocking curve measurement, and an angle between the incident X-ray and the crystal surface is represented by ω.

When the beam size of the X-ray is set as described above, the size of the irradiation area is about 1.7 × 5 mm² because ω is about 36.5° in the rocking curve measurement using X-ray diffraction of (004).

In addition, similar to the measurement of (004), a rocking curve measurement of other crystal planes can be performed. For example, a measurement of (201) is often performed.

The full width at half maximum in the rocking curve of (004) is an index for observing the uniformity of a plane parallel to the c-axis, that is, the c-plane. On the other hand, the full width at half maximum in the rocking curve of (201) is an index for observing the rotational uniformity around the c-axis of a plane not parallel to the c-axis, that is, the c-plane.

The rocking curve measurement of a plane parallel to the c-axis is referred to as an on-axis measurement, and the rocking curve measurement of a plane not parallel to the c-axis is referred to as an off-axis measurement. The former correlates with a dislocation density having a screw dislocation component, and the latter correlates with a dislocation density having an edge dislocation component. In order to evaluate the crystal quality, it is preferable to perform both the on-axis measurement and the off-axis measurement.

In the Zn-doped GaN layer in the present embodiment, an alkali metal concentration of the crystal surface is preferably 10 ppm or less. The Zn-doped GaN layer satisfying the above requirements means that a region having a partially high alkali metal concentration is not present in the Zn-doped GaN layer. As a region having a partially high alkali metal concentration is not present, the influence on a lattice length of the GaN crystal can be prevented, and cracking or the like can be prevented when a GaN crystal including a Zn-doped GaN layer is used as a substrate.

Note that ppm indicating the concentration in the present description means parts per million atomic (ppma) based on the number of atoms.

The alkali metal concentration of the crystal surface is more preferably 8 ppm or less, still more preferably 5 ppm or less, and is preferably as low as possible. The alkali metal concentration of the crystal surface is generally 0.1 ppm or more. The alkali metal concentration in the present description means an alkali metal concentration of any 100 µm × 100 µm square lattice on the crystal surface, and can be measured by, for example, scanning electron microscope-energy dispersive X-ray spectroscopy (SEM-EDX).

The Zn-doped GaN layer in the present embodiment preferably contains no alkali metal inclusions. The alkali metal inclusion means a closed space containing an alkali metal formed in the Zn-doped GaN layer when the alkali metal inclusion is present inside the crystal, and means a recessed portion formed by exposing the closed space to the crystal surface when the alkali metal inclusion is present on the crystal surface.

In the case where a GaN crystal including a Zn-doped GaN layer containing alkali metal inclusions inside the crystal or on the crystal surface is used as a substrate, when a GaN crystal layer is epitaxially grown on the substrate, the alkali metal such as Na, contained in the closed space volatilizes and expands in volume, which may cause cracking of the substrate, or may cause the crystal quality of the epitaxially grown GaN crystal layer to deteriorate. It is common that such a closed space can be generally generated in a GaN crystal when the GaN crystal is obtained by a flux method. The presence or absence of the alkali metal inclusions can be determined by an optical microscope or an SEM.

In the Zn-doped GaN layer in the present embodiment, it is also preferable that a peak of light emitted when the Zn-doped GaN is irradiated with light having energy larger than bandgap energy of GaN is not present in a region of 2.64 eV to 2.82 eV. Among the flux methods, for example, it is common that when a GaN crystal produced by the Na flux method is irradiated with the above light, broad light emission generally has a peak at 2.64 eV to 2.82 eV. It can be presumed that the GaN crystal is obtained by the Na flux method when the above peak is present.

As described above, the GaN crystal produced by the flux method may have a region having a high alkali metal concentration on the crystal surface or may have alkali metal inclusions, and may not be desirable as a semi-insulating GaN crystal for devices requiring high reliability.

In contrast, the Zn-doped GaN layer produced according to the vapor phase growth method emits light having a peak in a region of 2.88 eV to 2.98 eV by irradiating with the same light. The emission is derived from Zn and is distinguished from that derived from Na. Therefore, the Zn-doped GaN layer obtained according to the Na flux method and the Zn-doped GaN layer obtained according to the vapor phase method can be distinguished from each other based on the fact that no emission peak is present in the region of 2.64 eV to 2.82 eV or an emission peak is present in the region of 2.88 eV to 2.98 eV by irradiating with the above light.

As described above, the GaN crystal according to the first embodiment may be formed of a Zn-doped GaN crystal in which the Zn concentration of the entire crystal is 1.0 × 10¹⁶ atoms/cm³ or more and 1.0 × 10²⁰ atoms/cm³ or less, that is, may be formed of only the above Zn-doped GaN layer, and the GaN crystal may also have a configuration in which the above Zn-doped GaN layer having a Zn concentration of 1.0 × 10¹⁶ atoms/cm³ or more and 1.0 × 10²⁰ atoms/cm³ or less is laminated on a seed crystal layer formed of GaN

In the case where the GaN crystal includes the Zn-doped GaN layer and the seed crystal layer, the GaN crystal according to the first embodiment includes a first region 110 and a second region 120 as shown in FIG. 2.

FIG. 2 shows a cross section obtained by cutting a GaN crystal 100 along a plane perpendicular to a (0001) surface 101.

In the GaN crystal 100, the first region 110 including the (0001) surface 101 is preferably made of a Zn-doped GaN layer.

The GaN crystal 100 may have the second region 120 on a (000-1) surface 102 side, and the second region 120 may be made of a GaN crystal layer having a room temperature resistivity of less than 1 × 10⁵ Ωcm (that is, a GaN crystal layer that is not semi-insulating).

A total concentration of compensation impurities in the second region 120 is generally lower than that of the first region 110. The second region 120 may have, in a vicinity of a boundary with the first region 110, a region in which the total concentration of the compensation impurities increases stepwise or continuously as approaching the first region 110.

The GaN crystal 100 having the first region 110 and the second region 120 can be produced by forming the second region 120 on the first region 110 by epitaxial growth or forming the first region 110 on the second region 120 by epitaxial growth.

An example of the GaN crystal according to the first embodiment has the Ga polar (0001) surface 101 and the N polar (000-1) surface 102.

In the case where the GaN crystal 100 includes the seed crystal layer and the Zn-doped GaN layer, a surface of the first region 110 which is the Zn-doped GaN layer is the (0001) surface 101, and a surface of the second region 120 which is the seed crystal layer is the (000-1) surface 102, as shown in FIG. 2.

In the case where the GaN crystal 100 is formed of only a Zn-doped GaN layer as a whole, one surface of the Zn-doped GaN layer which is the first region 110 is the (0001) surface 101, and the other surface is the (000-1) surface 102, as shown in FIG. 3.

The Zn-doped GaN layer in the first embodiment preferably has a surface inclined by 10 degrees or less from the (0001) crystal plane. In the present description, the term "surface having inclination of 10 degrees or less from the (0001) crystal plane" may be abbreviated as a "(0001) surface". The expression "inclined by 10 degrees or less" is a concept also including the case of being inclined by 0 degree.

The GaN crystal according to the first embodiment may have any shape, and preferably has a shape from which a GaN substrate described later can be obtained.

An area of the (0001) surface of the Zn-doped GaN layer may be, for example, 1 cm² or more, 5 cm² or more, 10 cm² or more, 18 cm² or more, 75 cm² or more, or 165 cm² or more. The upper limit thereof is not particularly limited, and the area may be, for example, 350 cm² or less.

The GaN crystal according to the first embodiment may be grown in any direction, and is preferably grown on a surface inclined by 10 degrees or less (including 0 degree) from the (0001) crystal plane.

In the GaN crystal according to the first embodiment, the (0001) surface is preferably a main surface, that is, a large-area surface. In addition, an area ratio of the (0001) surface in the crystal growth surface is preferably 60% or more, more preferably 70% or more, and still more preferably 80% or more, and the upper limit is 100%.

When the area of the (0001) surface is large, the total donor impurity concentration can be kept low, and semi-insulating properties can be obtained even if the Zn concentration is relatively low, as described later. The same applies to the case where the area ratio of the (0001) surface to the crystal growth surface is within the above range.

When the GaN crystal according to the first embodiment has a disk shape, a diameter thereof is generally 20 mm or more, and may be 25 mm or more, 40 mm or more, 50 mm or more, or 90 mm or more in a stepwise manner. The above diameter may be any size such as 25 mm to 27 mm (about 1 inch), 50 mm to 55 mm (about 2 inches), 100 mm to 105 mm (about 4 inches), or 150 mm to 155 mm (about 6 inches). When the GaN crystal has a shape other than the disk shape, a size where the diameter of the disk shape having the same area as the main surface is within the above range can be adopted.

In the case of the GaN substrate, a thickness t of the GaN crystal is set, based on the diameter, to a value at which handling of the GaN substrate is not difficult. For example, when the diameter of the GaN crystal is about 2 inches, the thickness of the GaN crystal is preferably 250 µm to 500 µm, and more preferably 300 µm to 450 µm.

In the case where the GaN crystal has a configuration in which the second region 120 made of the seed crystal layer and the first region 110 made of the Zn-doped GaN layer are laminated as illustrated in FIG. 2, the thickness t₁ of the first region 110 that is the Zn-doped GaN layer is 50 µm or more, preferably 80 µm to 200 µm, and more preferably 100 µm to 150 µm.

In the case where the GaN crystal according to the first embodiment is a GaN substrate, the (0001) surface 101 of the two large-area surfaces of the GaN crystal is used for epitaxial growth of a nitride semiconductor layer as a front surface. The (0001) surface 101 is mirror-finished, and a root mean square (RMS) roughness thereof measured with an atomic force microscope (AFM) is generally less than 2 nm, preferably less than 1 nm, and more preferably less than 0.5 nm in a measurement range of 2 µm × 2 µm.

The (000-1) surface 102 is a back surface, and therefore, the plane may be mirror-finished or rough-finished.

An edge of the GaN substrate made of the GaN crystal according to the first embodiment may be chamfered.

The GaN substrate may be provided with various markings as necessary, such as orientation flats or notches for indicating an orientation of a crystal, and an index flat for facilitating the identification of a front surface and a back surface.

A shape of the GaN substrate is not particularly limited, and the shapes of the (0001) surface and the (000-1) surface may be a disk shape, a square shape, a rectangular shape, a hexagonal shape, an octagonal shape, an elliptical shape, or the like, or may be an irregular shape.

The Zn-doped GaN layer in the first embodiment preferably has a specific resistance of 1 × 10⁹ Ωcm or more at 300 K because the leakage current can be reduced when a GaN crystal is used as a high-resistance substrate for a device.

The specific resistance at 300 K is more preferably 5 × 10⁹ Ωcm or more, still more preferably 1 × 10¹⁰ Ωcm or more, yet still more preferably 2 × 10¹⁰ Ωcm or more, and particularly preferably 3 × 10¹⁰ Ωcm or more. In addition, the upper limit is not particularly limited because a higher specific resistance is more preferred.

In the Zn-doped GaN layer in the first embodiment, the carrier type is preferably p-type. In the case where the crystal quality of the GaN crystal is not good, even if the GaN layer is doped with Zn, electrons caused by unintended impurities such as Si and O cannot be sufficiently compensated, and the carrier type tends to be n-type. Therefore, the carrier type of the Zn-doped GaN layer being p-type means that the crystallinity of the GaN single crystal layer forming the GaN crystal is good.

### [GaN Crystal According to Second Embodiment]

A GaN crystal according to a second embodiment of Aspect B includes a Zn-doped GaN layer. The Zn-doped GaN layer has a Zn concentration of 1.0 × 10¹⁶ atoms/cm³ or more and 1.0 × 10²⁰ atoms/cm³ or less, a thickness of 50 µm or more, and a full width at half maximum of a rocking curve obtained by the (201) X-ray diffraction of the Zn-doped GaN layer is 50 arcsec or less.

A preferred aspect of the GaN crystal according to the second embodiment is the same as the contents described in [GaN Crystal According to First Embodiment].

The full width at half maximum of the rocking curve obtained by (201) X-ray diffraction of the Zn-doped GaN layer in the second embodiment is an index for observing rotational uniformity around the c-axis of a plane not parallel to the c-axis, that is, the c-plane, as described for the full width at half maximum of the rocking curve by (004) X-ray diffraction of the Zn-doped GaN layer in the first embodiment.

A smaller full width at half maximum of the rocking curve obtained by (201) X-ray diffraction means a better crystal quality. The above full width at half maximum of the Zn-doped GaN layer is 50 arcsec or less, preferably 40 arcsec or less, more preferably 30 arcsec or less, and still more preferably 20 arcsec or less. The lower limit of the full width at half maximum is not particularly limited, and the full width at half maximum is generally 5 arcsec or more.

Preferred aspects of the Zn-doped GaN layer and the GaN crystal other than the above full width at half maximum of the rocking curve are the same as the preferred aspects of the Zn-doped GaN layer and the GaN crystal described in [GaN Crystal According to First Embodiment].

In the Zn-doped GaN layer, both the full widths at half maximum of the rocking curves obtained by X-ray diffraction of (004) and (201) are preferably 50 arcsec or less, more preferably 40 arcsec or less, still more preferably 30 arcsec or less, and particularly preferably 20 arcsec or less.

### <<GaN Crystal (2)>>

Another GaN crystal according to the present embodiment includes a Zn-doped GaN layer.

The specific resistance at 300 K of the above Zn-doped GaN layer is 1 × 10⁹ Ωcm or more. The above Zn-doped GaN layer preferably has a Zn concentration of 1.0 × 10¹⁶ atoms/cm³ or more and 1.0 × 10²⁰ atoms/cm³ or less.

The specific resistance at 300 K of the above Zn-doped GaN layer is more preferably 5 × 10⁹ Ωcm or more, still more preferably 1 × 10¹⁰ Ωcm or more, still more preferably 5 × 10¹⁰ Ωcm or more, and particularly preferably 1 × 10¹¹ Ωcm or more. In addition, the upper limit is not particularly limited because a higher specific resistance is more preferred.

The GaN crystal according to the present embodiment achieves a high resistivity of a certain level or more while keeping the Zn concentration of the Zn-doped GaN layer within the upper and lower limit ranges described above, so that a decrease in crystal quality can be prevented, and an unexpected adverse effect on device characteristics can be reduced when the Zn concentration is extremely high exceeding the upper limit.

Other preferred aspects of the GaN crystal according to the present embodiment are the same as the preferred aspects of <<GaN crystal (1)>> above.

### <<Method for Producing GaN Crystal>>

A method for producing a GaN crystal according to the present embodiment is a method for producing a GaN crystal including a Zn-doped GaN layer having a Zn concentration of 1.0 × 10¹⁶ atoms/cm³ or more and 1.0 × 10²⁰ atoms/cm³ or less.

Here, in the case where the GaN crystal of the above aspect A is obtained as the GaN crystal, metallic Zn is used as a doping precursor. When the GaN crystal of the above aspect B is obtained as the GaN crystal, an organic Zn compound is used as a doping precursor.

Hereinafter, each production method will be described in detail.

### <Aspect A>

### (Method for Producing GaN Crystal)

The Zn-doped GaN layer of the GaN crystals according to the first embodiment and the second embodiment of the aspect A can be produced by, for example, a vapor phase growth method or a liquid phase growth method.

Examples of the vapor phase growth method include the HVPE method. Examples of the liquid phase growth method include an acidic ammonothermal method and a basic ammonothermal method. Among them, the HVPE method is preferred from the viewpoint of ease of production.

A third embodiment in aspect A of the present invention relates to a method for producing a GaN crystal.

The method for producing the GaN crystal according to the third embodiment of aspect A is a method for producing a Zn-doped GaN layer having a Zn concentration of 1.0 × 10¹⁶ atoms/cm³ or more and 1.0 × 10²⁰ atoms/cm³ or less by the vapor phase growth method. It is characterized by using the metallic Zn as a doping precursor.

The method for producing a GaN crystal preferably includes a first step shown in the following (i). This method is applied to production of a GaN substrate having a region on a N polarity side and a region on a Ga polarity side with a re-growth interface interposed therebetween, and more preferably, the specific resistance is increased in at least a part of the Ga polarity side.
(i) A first step of forming a Zn-doped GaN layer by growing a (0001)-oriented GaN layer on a c-plane GaN substrate seed by the vapor phase growth method.

In the present description, the term "on a substrate" and "on a substrate seed" have the same meaning as the term "on a surface of a substrate" and the term "on a surface of a substrate seed", respectively.

Hereinafter, the above first step will be described in more detail.

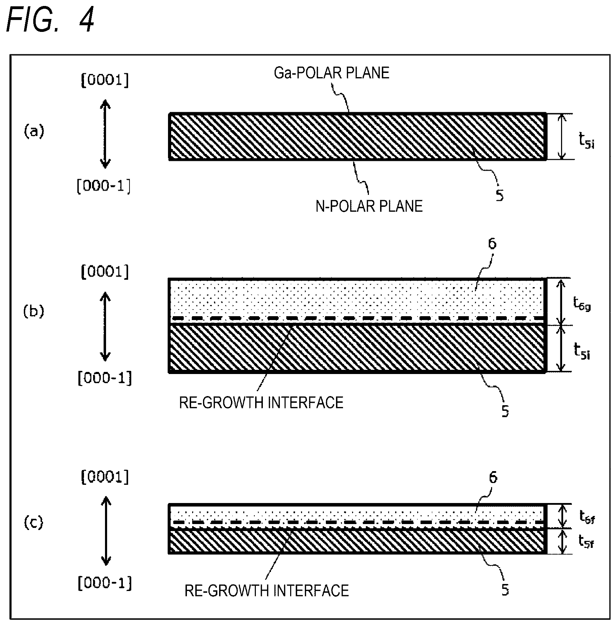

In the first step, a (0001)-oriented GaN layer 6 is grown on a Ga polar plane of a c-plane GaN seed 5 shown in (a) of FIG. 4, by the vapor phase growth method, preferably the HVPE method to obtain a GaN crystal as a laminated structure as shown in (b) of FIG. 4. A growth thickness t_{6g} of the GaN layer 6 is preferably 50 µm or more. At this time, a re-growth interface is formed between the c-plane GaN seed 5 and the GaN layer 6.

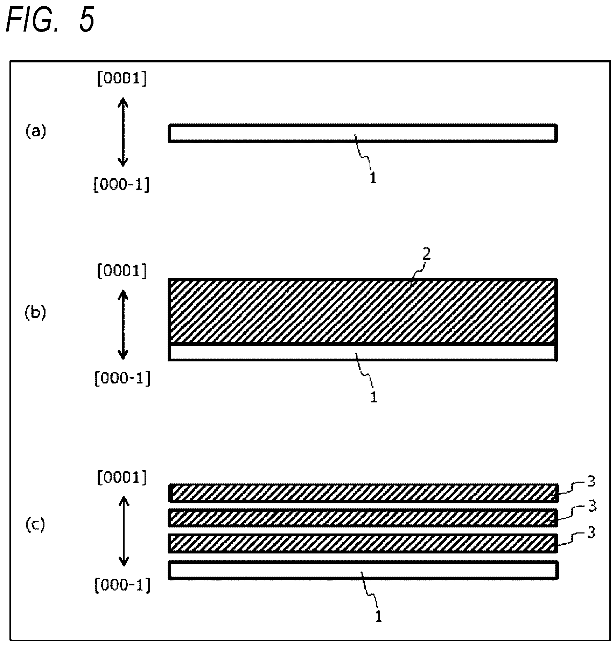

The method for obtaining the c-plane GaN seed used in the above first step is not particularly limited. For example, after a seed wafer 1 as shown in (a) of FIG. 5 is prepared, a (0001)-oriented thick GaN film 2 made of GaN that is not intentionally doped is grown on the seed wafer 1 by the vapor phase growth method, preferably the HVPE method as shown in (b) of FIG. 5. As shown in (c) of FIG. 5, one or more c-plane GaN seeds 3, which are substrates, can be obtained by processing the thick GaN film 2. An example of the seed wafer 1 is a c-plane sapphire wafer, and the seed wafer 1 is preferably provided with a release layer on a main surface thereof. A thick GaN film is further grown by the HVPE method or the like on the thus obtained c-plane GaN seed 3, and the c-plane GaN substrate obtained by the processing may be used as the c-plane GaN seed used for the above first step.

Generally, the Ga-polar plane of the c-plane GaN seed 5 is subjected to a flattening step, that is, a step of processing the Ga-polar plane into a flat surface by appropriately using a technique such as grinding, polishing, or a processing technique using a chemical polishing agent and a polishing pad called CMP before growing the GaN layer 6. The flattened Ga-polar plane may be subjected to a roughening step, that is, a step of processing into a rough surface by etching, and then the GaN layer 6 may be grown.

In the first step, at least a part of the GaN layer 6 is doped with Zn that is a compensation impurity.

It should be noted that doping with Fe as a compensation impurity in addition to Zn is not excluded.

The doping with Zn can be performed by a common method, and for example, the vapor phase growth method is preferred, and the HVPE method is more preferred. In the case where the vapor phase growth method is used, the metallic Zn is used as the doping precursor as described above. Specifically, the metallic Zn is used as vapor Zn obtained by heating.

The effect of using the metallic Zn as the doping precursor in the vapor phase growth method will be described in comparison with the related art.

Commonly, a method of using an organic Zn compound as a doping precursor when a GaN layer is subjected to crystal growth by a metal organic chemical vapor deposition (MOCVD) method has been known. In this method, a Zn-doped GaN crystal layer having excellent crystal quality can be obtained. However, an organic Zn compound is used as a doping precursor in the MOCVD method, and thus a concentration of C being equal to or larger than a certain concentration is inevitably contained in the Zn-doped GaN layer.

In contrast, in the production method according to the present embodiment, the concentration of C which is unintentionally contained in the Zn-doped GaN layer can be reduced to be lower than that in the related art. For example, the C concentration can be 1.0 × 10¹⁸ atoms/cm³ or less, by using the metallic Zn as the doping precursor. In particular, in the case where the HVPE method is used, the C concentration of the Zn-doped GaN layer can be reduced to about the detection limit.

Since C functions as a compensation impurity, it contributes to the improvement in the specific resistance. On the other hand, C may cause current collapse in the device, and thus the production method according to the present embodiment is extremely suitable in the case where it is intended to reduce the risk of occurrence of current collapse.

It has been commonly known that Fe or Mn is used as a compensation impurity element when doping with a compensation impurity is performed by a vapor phase growth method. However, it is common that the vapor pressure varies depending on the type of the compensation impurity and the ease of incorporation into the GaN crystal varies depending on the element. Thus, even if the doping conditions commonly applied to Fe or Mn are applied to Zn as they are, a simple prediction that appropriate doping is performed is not established. Therefore, it is essential to apply effective conditions in the case of Zn.

In the case where vapor Zn is used as the source gas in the vapor phase growth method, a growth rate is preferably 20 µm/hr or more from the viewpoint of high productivity, and is preferably 100 µm/hr or less from the viewpoint of stable crystal growth.

The partial pressure of the vapor Zn is adjusted such that the aforementioned Zn concentration is reached.

The growth thickness t_{6g} of the GaN layer 6 may be set according to a design thickness of the Ga polarity side region of the GaN crystal to be produced.

In the GaN crystal, even if the diameter of the wafer is 4 inches or 6 inches, the growth thickness t_{6g} of the GaN layer 6 can be reduced to 500 µm or less.

After the first step, as illustrated in (c) of FIG. 4, a thinning step of thinning the GaN layer 6 that is the laminated structure is provided as necessary.

In (c) of FIG. 4, a thickness of the c-plane GaN seed 5 is reduced from an initial thickness t₅ᵢ to a final thickness t_{5f}, and a thickness of the GaN layer 6 is reduced from a growth thickness t_{6g}, which is an initial thickness, to a final thickness t_{6f}. Alternatively, in the thinning step, only either one of the c-plane GaN seed 5 and the GaN layer 6 may be processed.

When an off-cut orientation of the GaN crystal to be produced and the off-cut of the c-plane GaN seed 5 are the same, a back surface of the c-plane GaN seed 5, that is, a N-polar surface of the laminated structure can be used as a reference of a plane orientation during the thinning process.

When the off-cut orientation of the GaN crystal to be produced is different from the off-cut of the c-plane GaN seed 5, that is, at least one of an off-cut angle and an off-cut direction is different, a crystal orientation of the GaN layer 6 to be the laminated structure is checked by an X-ray diffraction device before the thinning process.

The processing technique used in the thinning step can be appropriately selected from grinding, lapping, CMP, dry etching, wet etching, and the like.

The GaN crystal according to the present embodiment can be produced with a good yield by using the production method described above.

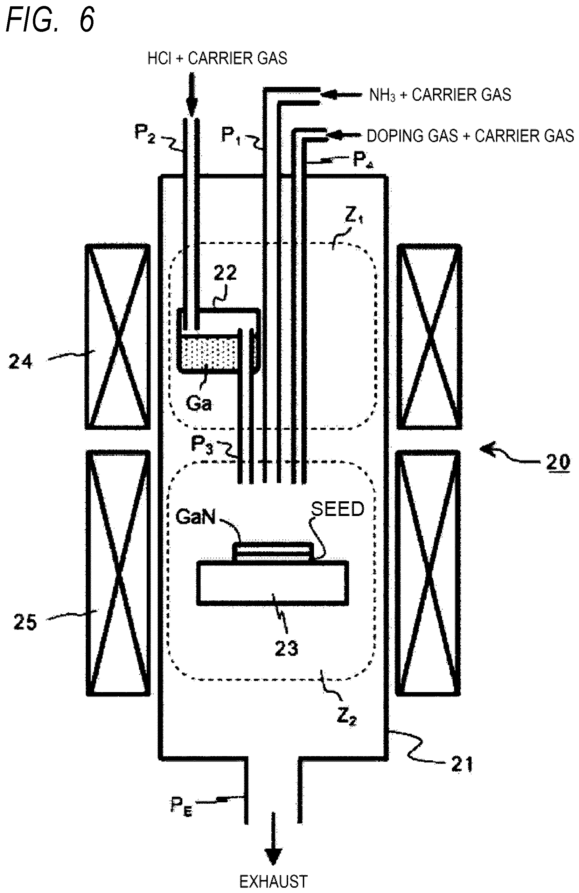

Next, an example of an HVPE device that can be used in the first step of the above-described production method will be described below with reference to FIG. 6.

An HVPE device 20 illustrated in FIG. 6 includes a hot-wall reactor 21, a gallium reservoir 22 and a susceptor 23 disposed in the reactor 21, and a first heater 24 and a second heater 25 disposed outside the reactor 21. The first heater 24 and the second heater 25 each annularly surround the reactor 21.

The reactor 21 is a quartz tube chamber. The reactor 21 includes a first zone Z1 mainly heated by the first heater 24 and a second zone Z2 mainly heated by the second heater 25. An exhaust pipe P_{E} is connected to an end of the reactor 21 on a second zone Z2 side.

The gallium reservoir 22 disposed in the first zone Z1 is a quartz container having a gas inlet and a gas outlet.

The susceptor 23 disposed in the second zone Z2 is formed of, for example, graphite. A mechanism for rotating the susceptor 23 may be freely provided.

In order to grow GaN by the HVPE device 20, a seed is placed on the susceptor 23, and an inside of the reactor 21 is heated by the first heater 24 and the second heater 25. At the same time, NH₃ (ammonia) diluted with a carrier gas is supplied to the second zone Z2 through an ammonia introduction pipe P₁, and HCl (hydrogen chloride) diluted with a carrier gas is supplied to the gallium reservoir 22 through a hydrogen chloride introduction pipe P₂. HCl reacts with the metallic gallium in the gallium reservoir 22, and the generated GaCl (gallium chloride) is carried to the second zone Z2 through a gallium chloride introduction pipe P₃.

NH₃ reacts with GaCl in the second zone Z2, and the generated GaN is crystallized on the seed placed on the susceptor 23.

When growing GaN is to be intentionally doped, a doping gas diluted with a carrier gas is guided to the second zone Z2 in the reactor 21 through a dopant introduction pipe P₄.

Portions of the ammonia introduction pipe P₁, the hydrogen chloride introduction pipe P₂, the gallium chloride introduction pipe P₃, and the dopant introduction pipe P₄ disposed in the reactor 21 are formed of quartz.

As the carrier gas for diluting each of NH₃, HCl, and the doping gas, H₂ (hydrogen gas), N₂ (nitrogen gas), or a mixed gas of H₂ and N₂ is preferably used.

Preferred conditions for growing GaN using the HVPE device 20 are as follows.

The temperature of the gallium reservoir 22 is, for example, 500°C to 1000°C, and preferably 700°C or higher, and is preferably 900°C or lower.

The temperature of the susceptor 23 is, for example, 900°C to 1100°C, preferably 930°C or higher, and more preferably 950°C or higher, and is preferably 1050°C or lower, and more preferably 1020°C or lower.

The V/III ratio, which is a ratio of a NH₃ partial pressure (V) to the GaCl partial pressure (III) in the reactor 21, is, for example, 1 to 20, preferably 2 or more, and more preferably 3 or more, and is preferably 10 or less.

An excessively small or excessively large V/III ratio causes the morphology of the GaN growth surface to deteriorate. Deterioration in the morphology of the growth surface may cause deterioration in the crystal quality.

In a certain type of impurity, the incorporation efficiency into the GaN crystal strongly depends on the crystal orientation of the growth surface. In the GaN crystal grown under the condition that the morphology of the growth surface is not good, the uniformity of the concentration of the impurities is reduced. This is because the growth surface with poor morphology has a variety of facets in various orientations.

A typical example of impurities whose incorporation efficiency into the GaN crystal is clearly different depending on the crystal orientation of the growth surface is O (oxygen). A decrease in the uniformity of the concentration of O leads to a decrease in the uniformity of the specific resistance because O is a donor impurity.

In addition, the use of an excessively low V/III ratio increases a nitrogen vacancy concentration of the growing GaN crystal. The effect of nitrogen vacancies on GaN crystals, GaN substrates using such crystals, and nitride semiconductor devices formed on such GaN substrates is not clear, and it is considered that the concentration is to be reduced as much as possible because the nitrogen vacancies are point defects.

The growth rate of GaN is preferably 40 µm/h to 200 µm/h, and can be controlled using the product of the NH₃ partial pressure and the GaCl partial pressure in the reactor as a parameter. An excessively high growth rate causes the surface morphology of growing GaN to deteriorate.

When the GaN layer 6 is doped in the aforementioned first step, it is preferable to gradually increase a supply rate of the doping gas to a predetermined value over several minutes or several tens of minutes from the start of the supply in order to prevent deterioration in morphology of the growth surface.

For the same reason, the supply of the doping gas is preferably started at a time point when the GaN layer 6 is grown by at least several micrometers. Specifically, when the GaN layer is formed in the first step, the doping gas is not supplied when the thickness of the GaN layer is at least 5 µm, preferably at least 10 µm in the initial stage of growth of the GaN layer, and the GaN layer is preferably grown as an undoped layer. Accordingly, no new dislocation occurs at an interface between the undoped layer and the doped layer, and the quality of the seed crystal can be maintained.

A method for causing the GaN layer 6 to contain a compensation impurity such as Zn is not limited, and a method for introducing a doping gas into the HVPE device is generally adopted.

The doping gas for doping with Zn is as described above. For example, in the case where the vapor Zn is used as the raw gas, the metallic Zn can be placed in the introduction pipe as the doping precursor, and the vapor Zn may be prepared on the spot by heating the metallic Zn. In the case where the vapor Zn is prepared on the spot in this manner, the vapor Zn is preferably purged for the first several minutes so that the concentration of the Zn gas becomes uniform. For example, the supply of GaCl may be started after purging Zn vapor for 5 minutes.

When the undoped layer is continuously doped with Zn, the hydrogen chloride concentration is preferably gradually increased. By gradually increasing the hydrogen chloride concentration, formation of a steep interface between the undoped layer and the Zn-doped layer in the crystal can be prevented, and therefore, the crystal quality is improved. Specifically, it is desirable to linearly increase the hydrogen chloride concentration required for the desired Zn doping concentration over 3 minutes or longer.

The GaN grown using the HVPE device 20 can contain O and Si at a concentration detectable by secondary ion mass spectrometry (SIMS) even when the GaN is not intentionally doped with O and Si.

The Si source is quartz (SiO₂) used for the reactor 21 or a pipe in the reactor 21, and the O source is either one or both of the quartz and moisture remaining or entering the reactor 21.

The components disposed in the reactor 21, including components not shown in FIG. 6, may be those formed of SiC (silicon carbide), SiNx (silicon nitride), BN (boron nitride), alumina, W (tungsten), Mo (molybdenum), or the like, in addition to quartz and carbon. By doing so, the concentration of impurity elements other than Si, O, and H in GaN grown using the HVPE device 20 can be independently set to 5 × 10¹⁵ atoms/cm³ or less unless intentional doping is performed.

An example of the method for producing the GaN crystal having a laminated structure has been described as the method for producing a GaN crystal according to the present embodiment, and the GaN crystal is not limited to a GaN crystal having a laminated structure.

For example, in the first step described above, the GaN crystal may also be obtained by growing the GaN layer 6 to have a thickness equal to or larger than a certain thickness to form a thick GaN film and slicing the thick GaN film. At this time, the obtained GaN crystal is formed only of the above-described GaN layer 6.

In the case where the above specific doped region having a high Zn concentration is selected as a region to be sliced in the above GaN crystal, the Zn concentration of all regions in the obtained GaN crystal is increased. That is, a GaN crystal including only a Zn-doped GaN layer without the c-plane GaN seed 5 can be obtained.

### <Aspect B>

### (Method for Producing GaN Crystal)

The Zn-doped GaN layer of the GaN crystal according to the first embodiment and the second embodiment of the aspect B can be produced by, for example, a vapor phase growth method or a liquid phase growth method.

Examples of the vapor phase growth method include the HVPE method. Examples of the liquid phase growth method include an acidic ammonothermal method and a basic ammonothermal method. Among them, the HVPE method is preferred from the viewpoint of ease of production.

A third embodiment in the aspect B of the present invention relates to a method for producing a GaN crystal.

The method for producing the GaN crystal according to the third embodiment of the aspect B is a method for producing a Zn-doped GaN layer having a Zn concentration of 1.0 × 10¹⁶ atoms/cm³ or more and 1.0 × 10²⁰ atoms/cm³ or less and a thickness of 50 µm or more by the vapor phase growth method. It is characterized by using an organic Zn compound as a doping precursor.

The method for producing a GaN crystal preferably includes a first step shown in the following (i). This method is applied to production of a GaN substrate having a region on a N polarity side and a region on a Ga polarity side with a re-growth interface interposed therebetween, and more preferably, the specific resistance is increased in at least a part of the Ga polarity side.
(i) A first step of forming a Zn-doped GaN layer by growing a (0001)-oriented GaN layer on a c-plane GaN substrate seed by the vapor phase growth method.

In the present description, the term "on a substrate" and "on a substrate seed" have the same meaning as the term "on a surface of a substrate" and the term "on a surface of a substrate seed", respectively.

Hereinafter, the above first step will be described in more detail.

In the first step, a (0001)-oriented GaN layer 6 is grown on a Ga polar plane of a c-plane GaN seed 5 shown in (a) of FIG. 4, by the vapor phase growth method, preferably the HVPE method to obtain a GaN crystal as a laminated structure as shown in (b) of FIG. 4. A growth thickness t_{6g} of the GaN layer 6 is 50 µm or more. At this time, a re-growth interface is formed between the c-plane GaN seed 5 and the GaN layer 6.

The method for obtaining the c-plane GaN seed used in the above first step is not particularly limited. For example, after a seed wafer 1 as shown in (a) of FIG. 5 is prepared, a (0001)-oriented thick GaN film 2 made of GaN that is not intentionally doped is grown on the seed wafer 1 by the vapor phase growth method, preferably the HVPE method as shown in (b) of FIG. 5. As shown in (c) of FIG. 5, one or more c-plane GaN seeds 3, which are substrates, can be obtained by processing the thick GaN film 2. An example of the seed wafer 1 is a c-plane sapphire wafer, and the seed wafer 1 is preferably provided with a release layer on a main surface thereof. A thick GaN film is further grown by the HVPE method or the like on the thus obtained c-plane GaN seed 3, and the c-plane GaN substrate obtained by the processing may be used as the c-plane GaN seed used for the above first step.

Generally, the Ga-polar plane of the c-plane GaN seed 5 is subjected to a flattening step, that is, a step of processing the Ga-polar plane into a flat surface by appropriately using a technique such as grinding, polishing, or a processing technique using a chemical polishing agent and a polishing pad called CMP before growing the GaN layer 6. The flattened Ga-polar plane may be subjected to a roughening step, that is, a step of processing into a rough surface by etching, and then the GaN layer 6 may be grown.

In the first step, at least a part of the GaN layer 6 is doped with Zn that is a compensation impurity.

It should be noted that doping with Fe as a compensation impurity in addition to Zn is not excluded.

The doping with Zn can be performed by a common method, and for example, the vapor phase growth method is preferred, and the HVPE method is more preferred. In the case where the vapor phase growth method is used, the organic Zn compound is used as the doping precursor as described above.

The effect of using the organic Zn compound as the doping precursor in the vapor phase growth method will be described in comparison with the related art.

Commonly, a method of using an organic Zn compound as a doping precursor when a GaN layer is subjected to crystal growth by a metal organic chemical vapor deposition (MOCVD) method has been known. In this method, a Zn-doped GaN crystal layer having excellent crystal quality may be obtained, but it is difficult to increase the thickness of the GaN crystal layer.

In contrast, in the production method according to the present embodiment, a crystal layer such as a Zn-doped GaN layer having a thickness of 50 µm or more is obtained by using a vapor phase growth method, preferably an HVPE method, for crystal growth and using the organic Zn compound as a doping precursor. In particular, a crystal having excellent crystal quality, which has not been achieved by the technique in the related art, can be obtained by performing crystal growth according to the HVPE method.

It has been commonly known that Fe or Mn is used as a compensation impurity element when doping with a compensation impurity is performed by a vapor phase growth method. However, it is common that the vapor pressure varies depending on the type of the compensation impurity and the ease of incorporation into the GaN crystal varies depending on the element. Thus, even if the doping conditions commonly applied to Fe or Mn are applied to Zn as they are, a simple prediction that appropriate doping is performed is not established. Therefore, it is essential to apply effective conditions in the case of Zn.

Examples of the raw material gas of the organic Zn compound used in the vapor phase growth method include diethyl Zn and dimethyl Zn, and diethyl Zn is more preferred from the viewpoint of stable crystal growth.

In the case where an organic Zn compound is used as a dopant precursor, a growth rate is preferably 20 µm/hr or more from the viewpoint of high productivity, and is preferably 100 µm/hr or less from the viewpoint of stable crystal growth.

The partial pressure of the organic Zn compound is adjusted such that the aforementioned Zn concentration is reached.

The growth thickness t_{6g} of the GaN layer 6 may be set according to a design thickness of the Ga polarity side region of the GaN crystal to be produced.

In the GaN crystal, even if the diameter of the wafer is 4 inches or 6 inches, the growth thickness t_{6g} of the GaN layer 6 can be reduced to 500 µm or less.

After the first step, as illustrated in (c) of FIG. 4, a thinning step of thinning the GaN layer 6 that is the laminated structure is provided as necessary.

In (c) of FIG. 4, a thickness of the c-plane GaN seed 5 is reduced from an initial thickness t₅ᵢ to a final thickness t_{5f}, and a thickness of the GaN layer 6 is reduced from a growth thickness t_{6g}, which is an initial thickness, to a final thickness t_{6f}. Alternatively, in the thinning step, only either one of the c-plane GaN seed 5 and the GaN layer 6 may be processed.

When an off-cut orientation of the GaN crystal to be produced and the off-cut of the c-plane GaN seed 5 are the same, a back surface of the c-plane GaN seed 5, that is, a N-polar surface of the laminated structure can be used as a reference of a plane orientation during the thinning process.

When the off-cut orientation of the GaN crystal to be produced is different from the off-cut of the c-plane GaN seed 5, that is, at least one of an off-cut angle and an off-cut direction is different, a crystal orientation of the GaN layer 6 to be the laminated structure is checked by an X-ray diffraction device before the thinning process.

The processing technique used in the thinning step can be appropriately selected from grinding, lapping, CMP, dry etching, wet etching, and the like.

The GaN crystal according to the present embodiment can be produced with a good yield by using the production method described above.

Next, an example of an HVPE device that can be used in the first step of the above-described production method will be described below with reference to FIG. 6.

An HVPE device 20 illustrated in FIG. 6 includes a hot-wall reactor 21, a gallium reservoir 22 and a susceptor 23 disposed in the reactor 21, and a first heater 24 and a second heater 25 disposed outside the reactor 21. The first heater 24 and the second heater 25 each annularly surround the reactor 21.

The reactor 21 is a quartz tube chamber. The reactor 21 includes a first zone Z1 mainly heated by the first heater 24 and a second zone Z2 mainly heated by the second heater 25. An exhaust pipe P_{E} is connected to an end of the reactor 21 on a second zone Z2 side.

The gallium reservoir 22 disposed in the first zone Z1 is a quartz container having a gas inlet and a gas outlet.

The susceptor 23 disposed in the second zone Z2 is formed of, for example, graphite. A mechanism for rotating the susceptor 23 may be freely provided.

In order to grow GaN by the HVPE device 20, a seed is placed on the susceptor 23, and an inside of the reactor 21 is heated by the first heater 24 and the second heater 25. At the same time, NH₃ (ammonia) diluted with a carrier gas is supplied to the second zone Z2 through an ammonia introduction pipe P₁, and HCl (hydrogen chloride) diluted with a carrier gas is supplied to the gallium reservoir 22 through a hydrogen chloride introduction pipe P₂. HCl reacts with the metallic gallium in the gallium reservoir 22, and the generated GaCl (gallium chloride) is carried to the second zone Z2 through a gallium chloride introduction pipe P₃.

NH₃ reacts with GaCl in the second zone Z2, and the generated GaN is crystallized on the seed placed on the susceptor 23.

When growing GaN is to be intentionally doped, a doping gas diluted with a carrier gas is guided to the second zone Z2 in the reactor 21 through a dopant introduction pipe P₄.

Portions of the ammonia introduction pipe P₁, the hydrogen chloride introduction pipe P₂, the gallium chloride introduction pipe P₃, and the dopant introduction pipe P₄ disposed in the reactor 21 are formed of quartz.

As the carrier gas for diluting each of NH₃, HCl, and the doping gas, H₂ (hydrogen gas), N₂ (nitrogen gas), or a mixed gas of H₂ and N₂ is preferably used.

Preferred conditions for growing GaN using the HVPE device 20 are as follows.

The temperature of the gallium reservoir 22 is, for example, 500°C to 1000°C, and preferably 700°C or higher, and is preferably 900°C or lower.

The temperature of the susceptor 23 is, for example, 900°C to 1100°C, preferably 930°C or higher, and more preferably 950°C or higher, and is preferably 1050°C or lower, and more preferably 1020°C or lower.

The V/III ratio, which is a ratio of a NH₃ partial pressure (V) to the GaCl partial pressure (III) in the reactor 21, is, for example, 1 to 20, preferably 2 or more, and more preferably 3 or more, and is preferably 10 or less.

An excessively small or excessively large V/III ratio causes the morphology of the GaN growth surface to deteriorate. Deterioration in the morphology of the growth surface may cause deterioration in the crystal quality.

In a certain type of impurity, the incorporation efficiency into the GaN crystal strongly depends on the crystal orientation of the growth surface. In the GaN crystal grown under the condition that the morphology of the growth surface is not good, the uniformity of the concentration of the impurities is reduced. This is because the growth surface with poor morphology has a variety of facets in various orientations.

A typical example of impurities whose incorporation efficiency into the GaN crystal is clearly different depending on the crystal orientation of the growth surface is O (oxygen). A decrease in the uniformity of the concentration of O leads to a decrease in the uniformity of the specific resistance because O is a donor impurity.

In addition, the use of an excessively low V/III ratio increases a nitrogen vacancy concentration of the growing GaN crystal. The effect of nitrogen vacancies on GaN crystals, GaN substrates using such crystals, and nitride semiconductor devices formed on such GaN substrates is not clear, and it is considered that the concentration is to be reduced as much as possible because the nitrogen vacancies are point defects.

The growth rate of GaN is preferably 40 µm/h to 200 µm/h, and can be controlled using the product of the NH₃ partial pressure and the GaCl partial pressure in the reactor as a parameter. An excessively high growth rate causes the surface morphology of growing GaN to deteriorate.

When the GaN layer 6 is doped in the aforementioned first step, it is preferable to gradually increase a supply rate of the doping gas to a predetermined value over several minutes or several tens of minutes from the start of the supply in order to prevent deterioration in morphology of the growth surface.

For the same reason, the supply of the doping gas is preferably started at a time point when the GaN layer 6 is grown by at least several micrometers. Specifically, when the GaN layer is formed in the first step, the doping gas is not supplied when the thickness of the GaN layer is at least 5 µm, preferably at least 10 µm in the initial stage of growth of the GaN layer, and the GaN layer is preferably grown as an undoped layer. Accordingly, no new dislocation occurs at an interface between the undoped layer and the doped layer, and the quality of the seed crystal can be maintained.

A method for causing the GaN layer 6 to contain a compensation impurity such as Zn is not limited, and a method for introducing a doping gas into the HVPE device is generally adopted.

The doping gas for Zn doping is as described above. For example, when diethyl Zn which is an organic metal, is used as a raw material gas, a cylinder of a diethyl Zn gas having any concentration is prepared, and Zn is introduced into the system by flowing it at a predetermined flow rate.

When the undoped layer is continuously doped with Zn, the flow rate of the diethyl Zn is preferably gradually increased. By gradually increasing the flow rate of the diethyl Zn, formation of a steep interface between the undoped layer and the Zn-doped layer in the crystal can be prevented, and therefore, the crystal quality is improved. Specifically, it is desirable to linearly increase the flow rate of the diethyl Zn required for the desired Zn doping concentration over 3 minutes or longer.

The GaN grown using the HVPE device 20 can contain O and Si at a concentration detectable by secondary ion mass spectrometry (SIMS) even when the GaN is not intentionally doped with O and Si.

The Si source is quartz (SiO₂) used for the reactor 21 or a pipe in the reactor 21, and the O source is either one or both of the quartz and moisture remaining or entering the reactor 21.

The components disposed in the reactor 21, including components not shown in FIG. 6, may be those formed of SiC (silicon carbide), SiNx (silicon nitride), BN (boron nitride), alumina, W (tungsten), Mo (molybdenum), or the like, in addition to quartz and carbon. By doing so, the concentration of impurity elements other than Si, O, and H in GaN grown using the HVPE device 20 can be independently set to 5 × 10¹⁵ atoms/cm³ or less unless intentional doping is performed.

An example of the method for producing the GaN crystal having a laminated structure has been described as the method for producing a GaN crystal according to the present embodiment, and the GaN crystal is not limited to a GaN crystal having a laminated structure.

For example, in the first step described above, the GaN crystal may also be obtained by growing the GaN layer 6 to have a thickness equal to or larger than a certain thickness to form a thick GaN film and slicing the thick GaN film. At this time, the obtained GaN crystal is formed only of the above-described GaN layer 6.

In the case where the above specific doped region having a high Zn concentration is selected as a region to be sliced in the above GaN crystal, the Zn concentration of all regions in the obtained GaN crystal is increased. That is, a GaN crystal including only a Zn-doped GaN layer without the c-plane GaN seed 5 can be obtained.

### <<Use of GaN Crystal>>

The GaN crystal according to the present embodiment can be preferably used for producing a nitride semiconductor device, particularly a nitride semiconductor device having a horizontal device structure, in any aspect including the aspect A and the aspect B. Specifically, the nitride semiconductor device can be produced by a method including a step of preparing the above GaN crystal, a step of preparing a substrate from the prepared GaN crystal, and a step of epitaxially growing one or more nitride semiconductor layers on the prepared substrate.

The nitride semiconductor is also referred to as a nitride-based Group III-V compound semiconductor, a group III nitride-based compound semiconductor, a GaN-based semiconductor, or the like, and includes not only GaN but also a compound obtained by substituting a part or all of gallium of GaN with other Group 13 elements (B, Al, In, or the like) of the periodic table.

A typical example of the nitride semiconductor device having a horizontal device structure is a GaN-HEMT, and the horizontal device structure may be adopted in an electronic device other than the HEMT such as a bipolar transistor, or in a light-emitting device such as a light-emitting diode (LED) or a laser diode (LD). Examples

The present invention will be described in detail below with reference to Examples, but the present invention is not limited to thereto.

### (Example A-1)

### 1. Epitaxial Growth of GaN Crystal

Using a vapor phase growth device equipped with a quartz hot wall reactor, a GaN crystal was epitaxially grown on a free-standing GaN seed having a square shape with a side length of 20 mm and a thickness of 400 µm by the HVPE method.

In this step, (1) a temperature increase step, (2) a GaN layer growth step, and (3) a cooling step described below were sequentially performed.

### (1) Temperature Increase Step

First, a free-standing GaN seed was placed in a reactor.

Next, a reactor temperature was increased from room temperature to 1030°C while supplying ammonia and a carrier gas to the free-standing GaN seed. Nitrogen gas was used as a carrier gas. With this step, a GaN substrate seed was obtained.

### (2) Zn-doped GaN Layer Growth Step

A mixed gas containing ammonia and gallium chloride as shown in the following growth conditions was supplied as a raw gas while maintaining the reactor temperature at 1030°C, thereby growing a Zn-doped GaN layer on the GaN substrate seed to have a thickness of 850 µm. As the Zn-doping precursor, vapor Zn obtained by heating metallic Zn to 409°C was used.

The growth rate was 83 µm/hr, and the growth conditions were as follows: a reactor pressure of 101 kPa; an ammonia partial pressure of 16.290 kPa; a GaCl partial pressure of 1.303 kPa; a nitrogen gas partial pressure of 83.407 kPa; and a vapor Zn partial pressure of 3.90 × 10⁻⁵ kPa.

Note that, for 13 minutes of the initial growth stage, an undoped layer was formed without flowing the vapor Zn.

The gas partial pressure (P_{G}) here is a value obtained by multiplying the reactor pressure (P_{R}) by a ratio (r) of a volume flow rate of the gas to a total volume flow rate of all the gases supplied into the reactor, that is, a value represented by P_{G} = r × P_{R}.

Next, the reactor temperature was increased to 1010°C while continuously supplying the raw gas and the carrier gas.

### (3) Cooling Step

After completion of the Zn-doped GaN layer growth step described in the above (2), the supply of gallium chloride to the GaN substrate seed was stopped, and the heating for the reactor was stopped to lower the reactor temperature to room temperature. The gas flowing into the reactor was ammonia and nitrogen gas until the temperature decreased to 600°C, and then only nitrogen gas was used.

The surface of the as-grown GaN crystal taken out from the reactor was a mirror surface over the entire surface and was flat. The color was light blue.

### 2. Production of c-Plane GaN Substrate

The as-grown GaN crystal obtained in the above 1. was subjected to laser coring to obtain a square epitaxial substrate having a side of 7 mm. Next, lapping and polishing of the +c-plane and the -c-plane were sequentially performed to complete a c-plane GaN substrate made of a GaN crystal including a Zn-doped GaN layer. In the processing step, a seed portion on a -c-plane side was completely removed by grinding.

The GaN crystal which is a c-plane GaN substrate had a total thickness of 400 µm and was formed of only a Zn-doped GaN layer.

### 3. Evaluation of c-Plane GaN Substrate

### <Measurement of Zn Concentration>

The Zn concentration of the c-plane GaN substrate obtained above was measured by SIMS.

As a result, the Zn concentration was 4 × 10¹⁷ atoms/cm³. The C concentration was about the measurement limit, and C was not substantially contained. The Si concentration was 8 × 10¹⁴ atoms/cm³. The O concentration was 8 × 10¹⁵ atoms/cm³. The GaN crystal of Example A-1 was grown by the HVPE method, and therefore, the alkali metal concentration of the crystal surface was 10 ppm or less, and it is presumed that the crystal did not contain alkali metal inclusions.

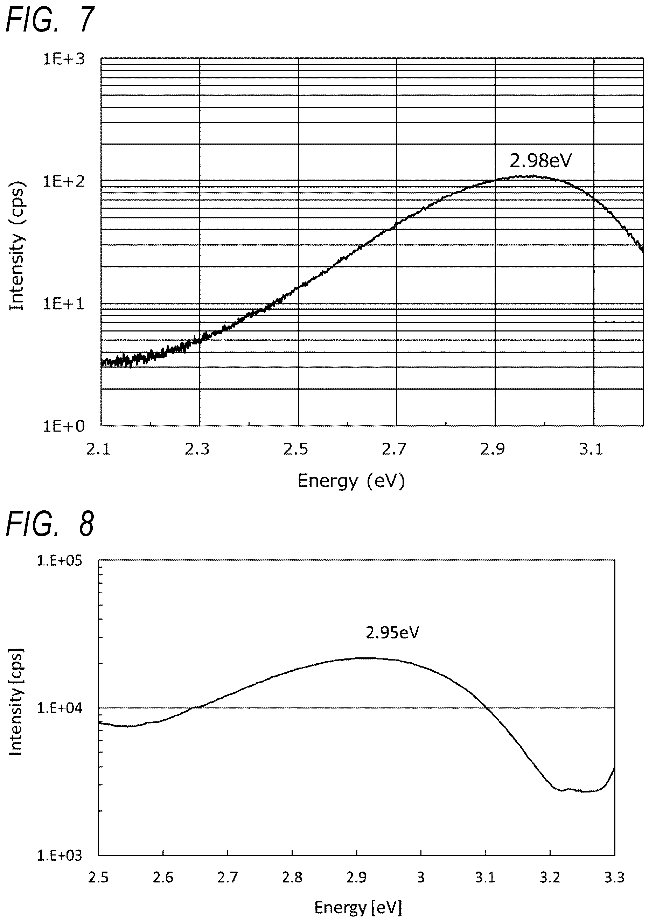

In addition, an emission spectrum of the grown crystal was obtained by a photoluminescence method. Specifically, the GaN crystal of Example A-1 was irradiated with a He-Cd laser having a wavelength of 325 nm (energy of 3.81 eV) as a light source for excitation. The obtained emission spectrum was shown in FIG. 7. As a result, there was a peak at 2.98 eV, and there was no peak in the region of 2.64 eV to 2.82 eV.

### <Measurement of Carrier Concentration, Specific Resistance, and Carrier Type>

Next, for the Hall effect measurement, Ti 30 nm and Au 100 nm were continuously vacuum-deposited on a surface of the c-plane GaN substrate obtained as described above. In the Hall effect measurement, a 4-terminal Van der Pauw method was used. As a result, the specific resistance at 300 K was 5.6 × 10¹¹ Ωcm.

The type of the carrier could not be properly distinguished by the Hall effect measurement.

### <Measurement of Rocking Curve Obtained by X-Ray Diffraction>

A rocking curve (XRC) obtained by X-ray diffraction of (004) reflection and X-ray diffraction of (201) reflection in the c-plane GaN substrate produced above was measured using an X-ray diffractometer (SmartLab manufactured by Rigaku Corporation) using CuKα 1 radiation as an X-ray source.

A Ge (440) 4 crystal monochromator was used as an incident optical system of the X-ray diffractometer. A size of a longitudinal limiting slit of an X-ray beam was set to 2 mm. An X-ray tube was operated at a voltage of 45 kV and a current of 40 mA.

The full width at half maximum (FWHM) of the rocking curve obtained by X-ray diffraction of (004) reflection was 18.6 arcsec. The full width at half maximum (FWHM) of the rocking curve by X-ray diffraction of (201) reflection was 24.7 arcsec.

### (Example B-1)

### 1. Epitaxial Growth of GaN Crystal

Using a vapor phase growth device equipped with a quartz hot wall reactor, a GaN crystal was epitaxially grown on a free-standing GaN seed having a square shape with a side length of 20 mm and a thickness of 400 µm by the HVPE method.

In this step, (1) a temperature increase step, (2) a GaN layer growth step, and (3) a cooling step described below were sequentially performed.

### (1) Temperature Increase Step

First, a free-standing GaN seed was placed in a reactor.

Next, a reactor temperature was increased from room temperature to 1030°C while supplying ammonia and a carrier gas to the free-standing GaN seed. Nitrogen gas was used as a carrier gas. With this step, a GaN substrate seed was obtained.

### (2) Zn-doped GaN Layer Growth Step

A mixed gas containing ammonia and gallium chloride as shown in the following growth conditions was supplied as a raw gas while maintaining the reactor temperature at 1030°C, thereby growing a Zn-doped GaN layer on the GaN substrate seed to have a thickness of 250 µm. Diethyl Zn having a concentration of 500 ppm, which was diluted with nitrogen gas, was used as the Zn doping precursor.

The growth rate was 83 µm/hr, and the growth conditions were as follows: a reactor pressure of 101 kPa; an ammonia partial pressure of 15.683 kPa; a GaCl partial pressure of 1.255 kPa; a nitrogen gas partial pressure of 834.062 kPa; and a diethyl Zn partial pressure of 1.25 × 10⁻³ kPa.

Note that, for 10 minutes of the initial growth stage, an undoped layer was formed without flowing the diethyl Zn.

The gas partial pressure (P_{G}) here is a value obtained by multiplying the reactor pressure (P_{R}) by a ratio (r) of a volume flow rate of the gas to a total volume flow rate of all the gases supplied into the reactor, that is, a value represented by P_{G} = r × P_{R}.

Next, the reactor temperature was increased to 1010°C while continuously supplying the raw gas and the carrier gas.

### (3) Cooling Step

After completion of the Zn-doped GaN layer growth step described in the above (2), the supply of gallium chloride to the GaN substrate seed was stopped, and the heating for the reactor was stopped to lower the reactor temperature to room temperature. The gas flowing into the reactor was ammonia and nitrogen gas until the temperature decreased to 600°C, and then only nitrogen gas was used.

The surface of the GaN crystal, which was a free-standing substrate taken out from the reactor was a mirror surface over the entire surface and was flat. The color was ocher.

### 2. Production of c-Plane GaN Substrate

The GaN crystal, which was a free-standing substrate obtained in the above 1., was subjected to laser coring to obtain a square epitaxial substrate having a side of 7 mm. Next, lapping and polishing of the +c-plane and the -c-plane were sequentially performed to complete a c-plane GaN substrate made of a GaN crystal including a Zn-doped GaN layer. In the processing step, a seed portion on a -c-plane side was completely removed by grinding.

The GaN crystal which is a c-plane GaN substrate had a total thickness of 240 µm and was formed of only a Zn-doped GaN layer.

### 3. Evaluation of c-Plane GaN Substrate

### <Measurement of Zn Concentration>

The Zn concentration of the c-plane GaN substrate obtained above was measured by SIMS.

As a result, the Zn concentration was 1 × 10¹⁹ atoms/cm³. The C concentration was 2 × 10¹⁸ atoms/cm³. The Si concentration was 8 × 10¹⁵ atoms/cm³. The O concentration was 8 × 10¹⁵ atoms/cm³. The GaN crystal of Example B-1 was grown by the HVPE method, and therefore, the alkali metal concentration of the crystal surface was 10 ppm or less, and it is presumed that the crystal did not contain alkali metal inclusions.

In addition, an emission spectrum of the grown crystal was obtained by a photoluminescence method. Specifically, the GaN crystal of Example B-1 was irradiated with a He-Cd laser having a wavelength of 325 nm (energy of 3.81 eV) as a light source for excitation. The obtained emission spectrum was shown in FIG. 8. As a result, there was a peak at 2.95 eV, and there was no peak in the region of 2.64 eV to 2.82 eV.

### <Measurement of Carrier Concentration, Specific Resistance, and Carrier Type>

Next, for the Hall effect measurement, Ti 30 nm and Au 100 nm were continuously vacuum-deposited on a surface of the c-plane GaN substrate obtained as described above. In the Hall effect measurement, a 4-terminal Van der Pauw method was used. As a result, the specific resistance at 300 K was 3.2 × 10¹⁰ Ωcm.

The type of the carrier could not be properly distinguished by the Hall effect measurement.

### <Measurement of Rocking Curve Obtained by X-Ray Diffraction>

A rocking curve (XRC) obtained by X-ray diffraction of (004) reflection and X-ray diffraction of (201) reflection in the c-plane GaN substrate produced above was measured using an X-ray diffractometer (SmartLab manufactured by Rigaku Corporation) using CuKα 1 radiation as an X-ray source.

A Ge (440) 4 crystal monochromator was used as an incident optical system of the X-ray diffractometer. A size of a longitudinal limiting slit of an X-ray beam was set to 2 mm. An X-ray tube was operated at a voltage of 45 kV and a current of 40 mA.

The full width at half maximum (FWHM) of the rocking curve obtained by X-ray diffraction of (004) reflection was 24.5 arcsec. The full width at half maximum (FWHM) of the rocking curve by X-ray diffraction of (201) reflection was 21.6 arcsec.

Although the present invention has been described in detail with reference to the specific embodiment, it will be apparent to those skilled in the art that various changes and modifications can be made without departing from the spirit and scope of the present invention. The present application is based on Japanese Patent Application No. 2022-140786 filed on September 5, 2022, and Japanese Patent Application No. 2022-140787 filed on September 5, 2022, contents of which are incorporated herein by reference.

### REFERENCE SIGNS LIST

1 seed wafer
2 thick GaN film
3 c-plane GaN seed
5 c-plane GaN seed
6 GaN layer
10 Zn-doped GaN crystal
11 (0001) surface
20 HVPE device
21 reactor
22 gallium reservoir
23 susceptor
24 first heater
25 second heater
100 GaN crystal
101 (0001) surface
102 (000-1) surface
110 first region
120 second region

## Claims

1. A GaN crystal comprising:
a Zn-doped GaN layer,
wherein the Zn-doped GaN layer has a Zn concentration of 1.0 × 10¹⁶ atoms/cm³ or more and 1.0 × 10²⁰ atoms/cm³ or less, and a full width at half maximum of a X-ray diffraction rocking curve of a (004) plane being 50 arcsec or less.

2. A GaN crystal comprising:
a Zn-doped GaN layer,
wherein the Zn-doped GaN layer has a Zn concentration of 1.0 × 10¹⁶ atoms/cm³ or more and 1.0 × 10²⁰ atoms/cm³ or less, and a full width at half maximum of a X-ray diffraction rocking curve of a (201) plane being 50 arcsec or less.

3. The GaN crystal according to claim 1 or 2, wherein the Zn-doped GaN layer has a C concentration of 1.0 × 10¹⁸ atoms/cm³ or less.

4. The GaN crystal according to claim 1 or 2, wherein the Zn-doped GaN layer has a thickness of 50 µm or more.

5. The GaN crystal according to claim 1 or 2, wherein an alkali metal concentration of a crystal surface of the Zn-doped GaN layer is 10 ppm or less.

6. The GaN crystal according to claim 1 or 2, wherein the Zn-doped GaN layer contains no alkali metal inclusions.

7. The GaN crystal according to claim 1 or 2, wherein a peak of light emitted when the Zn-doped GaN layer is irradiated with light having an energy larger than bandgap energy of GaN is not present in a region of 2.64 eV or more and 2.82 eV or less.

8. The GaN crystal according to claim 1 or 2, wherein the Zn-doped GaN layer has a specific resistance at 300 K of 1 × 10⁹ Ωcm or more.

9. The GaN crystal according to claim 1 or 2, wherein the Zn-doped GaN layer has a surface inclined by 10 degrees or less from a (0001) crystal plane.

10. The GaN crystal according to claim 1 or 2, wherein the Zn-doped GaN layer has a total donor impurity concentration of less than 5.0 × 10¹⁶ atoms/cm³.

11. The GaN crystal according to claim 1 or 2, wherein both an O (oxygen) content and a Si (silicon) content of the Zn-doped GaN layer are 1.0 × 10¹⁵ atoms/cm³ or more.

12. A GaN crystal comprising:
a Zn-doped GaN layer,
wherein the Zn-doped GaN layer has a specific resistance at 300 K of 1 × 10⁹ Ωcm or more.

13. A method for producing a GaN crystal by a vapor phase growth method, the GaN crystal including a Zn-doped GaN layer having a Zn concentration of 1.0 × 10¹⁶ atoms/cm³ or more and 1.0 × 10²⁰ atoms/cm³ or less, the method comprising:
using metallic Zn as a doping precursor.

14. A method for producing a GaN crystal by a vapor phase growth method, the GaN crystal including a Zn-doped GaN layer having a Zn concentration of 1.0 × 10¹⁶ atoms/cm³ or more and 1.0 × 10²⁰ atoms/cm³ or less and a thickness of 50 µm or more, the method comprising:
using an organic Zn compound as a doping precursor.

15. The method for producing a GaN crystal according to claim 13 or 14, wherein the vapor phase growth method is an HVPE method.
